(19) **Europäisches Patentamt / European Patent Office / Office européen des brevets**

(11) **EP 4 477 041 B1**

(12) **EUROPEAN PATENT SPECIFICATION**

(45) Date of publication and mention
of the grant of the patent:
**01.10.2025  Bulletin 2025/40**

(21) Application number: **23709827.2**

(22) Date of filing: **06.02.2023**

(51) International Patent Classification (IPC):
*H10N 30/88* (2023.01)    *H10N 30/02* (2023.01)
*H10N 30/077* (2023.01)   *H10N 30/00* (2023.01)
*H10N 30/857* (2023.01)

(52) Cooperative Patent Classification (CPC):
**H10N 30/077; H10N 30/092; H10N 30/706;
H10N 30/852**

(86) International application number:
**PCT/US2023/012424**

(87) International publication number:
**WO 2023/154249 (17.08.2023 Gazette 2023/33)**

(54) **STRUCTURALLY REINFORCED FERROELECTRIC ARTICLES OF MANUFACTURE AND METHODS OF MAKING AND USING THE SAME**

STRUKTURELL VERSTÄRKTE FERROELEKTRISCHE ARTIKEL UND VERFAHREN ZUR HERSTELLUNG UND VERWENDUNG DAVON

ARTICLES MANUFACTURÉS FERROÉLECTRIQUES STRUCTURALEMENT RENFORCÉS ET LEURS PROCÉDÉS DE FABRICATION ET D'UTILISATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **11.02.2022  US 202263309338 P**

(43) Date of publication of application:
**18.12.2024  Bulletin 2024/51**

(73) Proprietors:
• **W. L. Gore & Associates, Inc.
Newark, DE 19711 (US)**
• **W. L. Gore & Associates GmbH
85640 Putzbrunn (DE)**

(72) Inventors:
• **FRYDRYCH, Daniel J.
Newark, Delaware 85640 (US)**
• **SEIBERT, Klaus
85640 Putzbrunn (DE)**

(74) Representative: **HGF
HGF Limited
1 City Walk
Leeds LS11 9DX (GB)**

(56) References cited:
**WO-A1-2008/031657     WO-A1-2010/008133
TW-A- 201 347 564**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 477 041 B1

# EP 4 477 041 B1

## Description

### CROSS-REFERENCE TO RELATED APPLICATION

This application claims the benefit of Provisional Application No. 63/309,338, filed February 11, 2022.

### FIELD OF THE INVENTION

The present invention relates generally to ferroelectric materials reinforced with structural components to create articles of manufacture that exhibit good ferroelectric properties and improved structural properties.

### BACKGROUND OF THE INVENTION

Ferroelectricity is a characteristic of certain materials that have a spontaneous electric polarization that can be reversed by the application of an external electric field. Ferroelectric materials also exhibit piezoelectric properties. A variety of ferroelectric materials exist, including ferroelectric ceramics and ferroelectric polymers. Some of these ferroelectric materials also exhibit relaxor ferroelectric properties. Examples of ferroelectric polymers include, but are not limited to, vinylidene fluoride (VDF) copolymers (e.g., poly (vinylidene fluoride-trifluoroethylene) (p(VDF-TrFE)) and VDF terpolymers (e.g., poly (vinylidene fluoride-trifluoroethylene-chlorofluoroethylene (p(VDF-TrFE-CFE) and poly (vinylidene fluoride-trifluoroethylene-chlorotrifluoroethylene) (p(VDF-TrFE-CTFE).

Applications for ferroelectric materials include, but are not limited to sensors, energy storage, nonvolatile memory storage, transducers, actuators, and electrocaloric heating/cooling. However, many of these ferroelectric materials lack sufficient strength or formability to be used in certain applications. As such, reinforcement materials are often included when fabricating ferroelectric articles. Many reinforcement materials may negatively impact the electrical performance (relative to the unsupported ferroelectric material) and/or suffer from a lack of strength, lack of a suitable stiffness/flexibility or may not be sufficiently inert to the environmental conditions (chemical stability, thermal stability, etc.) for the target application. Lastly, many reinforcements may not durably bond the ferroelectric material and/or electrodes or may need to be removable.

The problem to be solved is to provide ferroelectric articles comprising reinforced ferroelectric materials where the presence of the reinforcement provides the desired mechanical properties enabling the formation of thinner, stronger articles having electroactivity suitable for a variety of applications.

TW 201 347 564 A shows piezoelectric actuator mounted on or within a polymer film and used as a speaker.

WO 2010/008133 A1 shows a device comprising an electroactive material mounted on a base substrate which may be made of plastic.

WO 2008/031657 A1 shows a piezoelectric actuator or sensor comprising an active material and electrodes embedded in a polymer carrier.

### SUMMARY OF THE INVENTION

The stated problem has been solved by providing ferroelectric articles comprising electrodes electrically coupled to a composite film having a ferroelectric material durably bound to a polymeric reinforcement membrane. Mechanical reinforcement enabled the formation of thin, strong, and tough films having electroactivity suitable for various product applications. Thinner films enable higher polarization when stimulated by lower driving voltages, improved film handling that facilitates the ability to include additional processing steps (e.g., deposition of electrodes, formation of multilayered structures and composites with additional materials, such as VDF terpolymers/relaxor ferroelectrics, and simplifies fabrication into end use articles/devices). The ferroelectric articles may comprise a plurality of the durable composite films arranged into various configurations (stacked, spiral, etc.).

According to one example ("Example 1"), a ferroelectric article includes a composite film having a first side and a second side, the composite film includes a ferroelectric material, and a polymeric reinforcement membrane; a first electrode electrically coupled to the first side of the composite film; and a second electrode electrically coupled to the second side of the composite film.

According to another example ("Example 2"), further to Example 1, the polymeric reinforcement membrane includes a compacted and/or retracted membrane comprising macro-structured folds and/or micro-folded fibrils.

According to another example ("Example 3"), further to Example 1, the ferroelectric material includes a ferroelectric polymer, a ferroelectric ceramic or a combination thereof.

According to another example ("Example 4"), further to any preceding Example, the ferroelectric polymer includes a vinylidene difluoride (VDF) copolymer or terpolymer.

According to another example ("Example 5"), further to any preceding Example, the ferroelectric polymer includes one or more of the following: poly(vinylidene fluoride-trifluoroethylene-chlorofluoroethylene)(VDF-TrFE-CFE), poly(vinylidene fluoride-trifluoroethylene-chlorotrifluoroethylene)( P(VDF-TrFE-CTFE), poly(vinylidene fluoride-trifluoroethylene)(VDF-TrFE), or a combination thereof.

According to another example ("Example 6"), further to any preceding Example, the ferroelectric ceramic includes one or more of the following: barium strontium titanate (BST), barium zirconium titanate (BZT), PZT (lead, zirconium, titanium, oxygen), $PbTiO_3$ (PT), $Pb(Mg_{1/3}Nb_{2/3})O_3$ (PMN), $Pb(Mg_{1/3}Nb_{2/3})O_3$-$PbTiO_3$ (PMN-PT), $LiTaO_3$, or a combination thereof.

According to another example ("Example 7"), further to any preceding Example, the ferroelectric ceramic includes one or more of the following: nanoparticles, nanowires, nanorods, nanocubes, nanofillers, or a combination thereof.

According to another example ("Example 8"), further to any preceding Example, the ferroelectric material includes a ferroelectric polymer and a ferroelectric ceramic particle filler.

According to another example ("Example 9"), further to any preceding Example, the polymeric reinforcement membrane includes a microporous membrane having pores, said microporous membrane including a polyolefin, a fluorinated polyolefin or a combination thereof.

According to another example ("Example 10"), further to any preceding Example, the polymeric reinforcement membrane includes one or more of the following: ultra-high molecular weight polyethylene (UHMWPE), polytetrafluoroethylene (PTFE), polyparaxylylene (PPX), vinylidene fluoride (VDF) copolymers (VDF-co-TFE or TrFE), ethylene tetrafluoroethylene (ETFE), poly (tetramethyl-p-silphenylene siloxane) (PTMPS), or a combination thereof.

According to another example ("Example 11"), further to any preceding Example, the polymeric reinforcement membrane includes an expanded polymer having a microstructure of nodes interconnected by fibrils and a void volume defining a plurality of pores, an expanded polymer having a microstructure of substantially only fibrils and a void volume defining a plurality of pores, or a combination thereof.

According to another example ("Example 12"), further to Example 11, the expanded polymer includes one or more of the following: expanded polytetrafluoroethylene (ePTFE), expanded ultra-high molecular weight polyethylene (ePE), expanded polyparaxylylene (ePPX), expanded VDF-co-TFE copolymer, expanded VDF-co-TrFE copolymer, expanded ethylene tetrafluoroethylene (eETFE), expanded poly (tetramethyl-p-silphenylene siloxane (ePTMPS), or a combination thereof.

According to another example ("Example 13"), further to Examples 11 or 12, wherein the microstructure of nodes, fibrils or a combination thereof of the expanded polymer is partially or fully coated with conductive metal coating to define a coated microstructure, and further wherein the coated microstructure retains at least a portion of the void volume after coating.

According to another example ("Example 14"), further to any preceding Example, the ferroelectric material forms a coating on the reinforcement membrane.

According to another example ("Example 15"), further to Examples 11 or 12, the ferroelectric material is partially or fully imbibed within the void volume of the reinforcement membrane.

According to another example ("Example 16"), further to any preceding Example, the ferroelectric polymer includes one or more of following: poly(vinylidene fluoride-trifluoroethylene-chlorofluoroethylene)(VDF-TrFE-CFE), poly(vinylidene fluoride-trifluoroethylene-chlorotrifluoroethylene)( P(VDF-TrFE-CTFE), poly(vinylidene fluoride-trifluoroethylene)(VDF-TrFE) or a combination thereof, and further wherein the ferroelectric polymer is partially or fully imbibed within the reinforcement membrane of expanded ePTFE.

According to another example ("Example 17"), further to any preceding Example, the composite film is equal to or greater than 1 $\mu$m and less than or equal to 20 $\mu$m thick.

According to another example ("Example 18"), further to Example 17, the composite film is equal to or greater than 1 $\mu$m and less than or equal to 10 $\mu$m thick.

According to another example ("Example 19"), further to any preceding Example, the polymeric reinforcement membrane has a mass per area of 5 $g/m^2$ or less.

According to another example ("Example 20"), further to Example 19, the polymeric reinforcement membrane has a mass per area of 4 $g/m^2$ or less.

According to another example ("Example 21"), further to Example 19 , the polymeric reinforcement membrane has a mass per area of 3 $g/m^2$ or less.

According to another example ("Example 22"), further to any preceding Example, the composite film has a total weight, and further the composite film includes 20 wt. % or less of the reinforcement membrane based upon the total weight of the composite film and 80 wt. % or more of the ferroelectric material based upon the total weight of the composite film.

According to another example ("Example 23"), further to any preceding Example, the composite film has a total weight, and further wherein the composite film includes 15 wt. % or less of the reinforcement membrane based upon the total weight of the composite film and 85 wt. % or more of the ferroelectric material based upon the total weight of the composite film.

According to another example ("Example 24"), further to any preceding Example, the composite film has a total weight, and further wherein the composite film includes 10 wt. % or less of the reinforcement membrane based upon the total weight of the composite film and 90 wt. % or more of the ferroelectric material based upon the total weight of the composite film.

According to another example ("Example 25"), further to any preceding Example, the reinforcement membrane is biaxially oriented and ha a machine direction (MD) matrix tensile strength of at least 30 MPa; and a transverse direction (TD) matrix tensile strength of at least 30 MPa.

According to another example ("Example 26"), further to Example 19, the ratio of the MD matrix tensile strength to TD matrix tensile strength is 1.0 : 0.1 to 0.1 : 1.0

According to another example ("Example 27"), further to Examples 19-21, the reinforcement membrane comprises a porosity of at least 30% as measured prior to addition of the ferroelectric material.

According to another example ("Example 28"), further to any preceding Example, the top and/or bottom electrode includes: a) a layer of a conductive metal of alumina no more than 80 nm thick; b) a layer of conductive thermoplastic of poly(3,4-ethylenedioxythiophene) polystyrene sulfonate (PEDOT:PSS); c) a layer of conductive ink comprising silver nanoparticles or silver nano wire inks deposited by digital printing, spraying, screen printing; or any combination of a, b, or c.

According to another example ("Example 29"), further to any preceding Example, the ferroelectric composite comprises a plurality of the composite films in a stacked configuration.

According to another example ("Example 30"), further to Example 29, the plurality of composite films include a laminated structure.

According to another example ("Example 31"), further to Examples 28 or 30, where at least one of the composite films in the stacked configuration is different from at least one of other composite films in the material.

According to another example ("Example 32"), further to Examples 28 to 31 where at least of the composite films in the stacked configuration is of a different thickness than is at least one of the other films in the material.

According to another example ("Example 33"), further to Examples 28 to 32 where at least of the composite films in the stacked configuration is of a different strength than is at least one of the other films in the material.

According to another example ("Example 34"), further to Examples 27 to 31 where at least of the composite films in the stacked configuration is of a different orientation than is at least one of the other films in the material.

According to another example ("Example 35"), a device comprising the ferroelectric article of any preceding Example.

According to another example ("Example 36"), a method of making the ferroelectric article, the method includes providing a polymeric reinforcement membrane having a first side and a second size; the polymeric reinforcement membrane having microstructure of nodes interconnected by fibrils or having a microstructure of substantially only fibrils, the microstructure further defining a void volume defining a plurality of pores; applying a ferroelectric material to the polymeric reinforcement membrane whereby reinforced ferroelectric composite is formed; and applying to the reinforced ferroelectric composite: at least one first electrode to said first side; and at least one second electrode to said second side; whereby a ferroelectric article is formed.

The foregoing Examples are just that and should not be read to limit or otherwise narrow the scope of any of the invention as solely defined by the claims. While multiple examples are disclosed, still other embodiments will become apparent to those skilled in the art from the following detailed description, which shows and describes illustrative examples. Accordingly, the drawings and detailed description are to be regarded as illustrative in nature rather than restrictive in nature.

## BRIEF DESCRIPTIONS OF FIGURES

The accompanying drawings are included to provide a further understanding of the disclosure and are incorporated in and constitute a part of this specification, illustrate embodiments, and together with the description serve to explain the principles of the disclosure.

FIG. 1 is a cross-sectional scanning electron micrograph (SEM) of the monolithic film from Example 1.

FIG. 2 is a graphical illustration of the differential scanning calorimetry (DSC) results of samples prepared in Example 1 and Example 2.

FIG. 3 is a graphical illustration of the tensile test results in the machine (down-web) direction of the monolithic films prepared in Examples 1 and 2.

FIG. 4 is a graphical illustration of the tensile test results in the transverse direction of the monolithic films prepared in Examples 1 and 2.

FIG. 5 is a cross-sectional SEM of the annealed monolithic film in Example 2.

FIG. 6 is a graphical illustration of the voltage breakdown test shown in the Weibull Plot of the annealed monolithic film from Example 2.

FIG. 7 is a graphical illustration of the polarization data for the monolithic film in Example 2.

FIG. 8 is a cross-sectional SEM of the composite film prepared in Example 3.

FIG. 9 is a cross-sectional SEM of the composite film prepared in Example 4.

FIG. 10 is a graphical illustration of the polarization data for the composite film from Example 4.

FIG. 11 is a cross-sectional SEM of the composite film prepared in Example 5.

FIG. 12 is a graphical illustration of the polarization data for the composite film from Example 6.

FIG. 13 is a cross-sectional SEM of the composite film prepared in Example 7.

FIG. 14 is a graphical illustration of the polarization data for the composite film from Example 7.

FIG. 15 is a graphical illustration on of the polarization data for the composite film from Example 8.

FIG. 16 is a graphical illustration of the polarization data for the composite film from Example 9.

FIG. 17 is a graphical illustration of the polarization data for the composite film from Example 10.

FIG. 18 is a graphical illustration of the polarization data for the composite film from Example 11.

FIG. 19 is a cross-sectional SEM of the composite film prepared in Example 12.

FIG. 20 is a graphical illustration of the tensile test results for two different reinforced terpolymer based composite films prepared in Example 12 and Example14 in the machine direction (MD) and transverse direction (TD).

FIG. 21 is a graphical illustration of the polarization data for the composite film in Example 12.

FIG. 22 is a graphical illustration of the polarization data for the composite film from Example 13.

FIG. 23 is a graphical illustration of the dynamic tensile test results in the transverse direction (TD) for the composite film prepared in Example 14.

FIG. 24 is a graphical illustration of the polarization data for the composite film from Example 14.

FIG. 25 is a cross-sectional SEM of the composite film prepared in Example 15.

FIG. 26 is a graphical illustration of the polarization data for the composite film from Example 15.

FIG. 27 is a graphical illustration of the polarization data for composite film from Example 16.

FIG. 28 is a cross-sectional SEM of the composite film prepared in Example 18.

FIG. 29 is a graphical illustration of the polarization data for the composite film from Example 18.

## DETAILED DESCRIPTION OF THE INVENTION

Persons skilled in the art will readily appreciate that various aspects of the present disclosure can be realized by any number of methods and apparatus configured to perform the intended functions. It should also be noted that the accompanying figures referred to herein are not necessarily drawn to scale and may be exaggerated to illustrate various aspects of the present disclosure, and in that regard, the figures should not be construed as limiting.

### Definitions

As used herein, "electroactive polymers" or "EAPs" refers to polymers that exhibit a change in size or shape when stimulated by an electric field.

As used herein, "piezoelectric" refers to materials capable to accumulate electrical charges in response to applied mechanical stress. It is a reversible process; the reversible piezoelectric effect results in the internal generation of a mechanical strain resulting from an applied electrical field.

As used herein, "ferroelectric materials" refers to materials capable of a spontaneous electric polarization that can be reversed or switched in an external electrical field. Examples may include ferroelectric ceramics, ferroelectric polymers, and combinations thereof. Typically, ferroelectricity is observed only below a certain phase transition temperature, called the Curie temperature (TC), and are paraelectric above this temperature: the spontaneous polarization vanishes, and the ferroelectric material transforms into the paraelectric state.

As used herein, "ferroelectric polymers" refers to a group of crystalline polar polymers that are also ferroelectric, meaning that they maintain a permanent electric polarization that can be reversed, or switched, in an external electric field.

As used herein, "relaxor ferroelectric" refers to a group of ferroelectric materials that exhibit high electrostriction. They change shape, i.e., increase of surface area and decrease in thickness, under the application of an electrical field.

As used herein, "relaxor ferroelectric polymers" refers to polymers exhibiting both high dielectric constants and low remnant polarization and thus deliver much higher energy densities and greater charge-discharge efficiencies than normal ferroelectrics for capacitive energy storage applications.

As used herein, "ferroelectric article" refers to a composite film comprising a polymeric reinforcement membrane (non-removable) + a ferroelectric material, the composite film having a first side and a second side with at least one electrode electrically coupled to the first side and at least one electrode coupled to the second side.

As used herein, "electrocaloric effect" refers to a phenomenon in which a material with dipolar constituents, that is, with certain dielectric properties, shows a reversible temperature change under an applied electric field under adiabatic conditions.

As used herein, the terms "compacted", "retracted" or "structured" may be used interchangeably when referring to a polymeric reinforcement membrane that is compacted in one or more of the transverse direction or machine direction prior to the application of the ferroelectric material. It is to be understood that the compaction is not limited to one direction: it may be done in the transverse direction, machine direction, or in both directions, either sequentially or simultaneously. In one exemplary embodiment, the polymeric reinforcement membrane is compacted in the transverse direction prior to the application of the ferroelectric polymer material. The polymeric reinforcement membrane subjected to compaction forms macro-structured folds and/or micro-folded fibrils in the membrane, giving the polymeric reinforcement membrane low modulus and flexibility. The compacted polymeric reinforcement membrane may also or alternatively demonstrate out-of-plane geometries such as wrinkles or folds in the membrane, such as, but not limited to, the methods described in EP3061598 A1 to Zaggl et al. and US Patent No. 9,849,629 to Zaggl, et al. It is to be noted that heat shrinkage or solvent shrinkage or other suitable method may alternatively be used to non-mechanically "compact" the polymeric reinforcement membrane.

## Polymeric Reinforcement Membranes

The polymeric reinforcement membrane is a microporous membrane that may be prepared from a variety of polymers. In one embodiment, the polymeric reinforcement membraned comprises a fibrillated microstructure. In a preferred aspect, the fibrillated microstructure comprises nodes interconnected by fibrils (see U. S. Patent 3,953,566 to Gore for an example of a node and fibril microstructure).

The polymeric reinforcement membrane is prepared from a fibrillatable polymer. Specific examples of fibrillatable polymers (e.g., capable of being processed into a membrane having a node and fibril microstructure) include, but are not limited to ultrahigh molecular weight polyethylene (UHMWPE) (U.S. Patent No. 10,577,468 to Sbriglia), polylactic acid (PLLA; U.S. Patent No. 9,732,184 to Sbriglia), copolymers of vinylidene fluoride with tetrafluoroethylene or trifluoroethylene (e.g. VDF-co-(TFE or TrFE) polymers; U.S. Patent No. 10,266,670 to Sbriglia), poly (ethylene tetrafluoroethylene) (ETFE; U.S. Patent No. 9,932,429 to Sbriglia), polyparaxylylene (PPX; U.S. Pat. Appl. Publ. No. 2016-0032069 to Sbriglia), polytetrafluoroethylene (PTFE; U.S. Patent Nos. 3,315,020 to Gore; 3,953,566 to Gore; and 7,083,225 to Baille), and (tetramethyl-p-silphenylenesiloxane) (PTMPS) (see Int. Pat. Appl. Publ. No. WO2021/202628 A1).

In at least one embodiment, the polymeric reinforcement membrane is a porous fluoropolymer membrane. In at least one exemplary embodiment, the polymeric reinforcement membrane is a polytetrafluoroethylene (PTFE) membrane or an expanded polytetrafluoroethylene (ePTFE) membrane. In a preferred aspect, the polymeric reinforcement membrane is an expanded polytetrafluoroethylene membrane. Expanded polytetrafluoroethylene (ePTFE) membranes prepared in accordance with the methods described in U.S. Patent No. 7,306,729 to Bacino et al., U.S. Patent No. 3,953,566 to Gore, U.S. Patent No. 5,476,589 to Bacino, or U.S. Patent No. 5,183,545 to Branca et al. may be used herein. In one preferred aspect, the polymeric reinforcement membrane is an ePTFE membrane as described in U.S. 7,306,729.

It is to be understood that throughout the application, the term "PTFE" is utilized herein for convenience and is meant to include not only polytetrafluoroethylene, but also expanded PTFE, expanded modified PTFE, and expanded copolymers of PTFE, such as described in U.S. Patent No. 5,708,044 to Branca, U.S. Patent No. 6,541,589 to Baillie, U.S. Patent No. 7,531,611 to Sabol et al., U.S. Patent No. 8,637,144 to Ford, and U.S. Patent No. 9,139,669 to Xu et al.

The porous fluoropolymer membrane may also include a polymer material that includes a functional tetrafluoroethylene (TFE) copolymer material where the functional TFE copolymer material includes a functional copolymer of TFE and PSVE (perfluorosulfonyl vinyl ether), or TFE with another suitable functional monomer, such as, but not limited to, vinylidene fluoride (VDF), vinyl acetate, or vinyl alcohol. A functional TFE copolymer material may be prepared, for example, according to the methods described in U.S. Patent No. 9,139,707 to Xu et al. or U.S. Patent No. 8,658,707 to Xu et al.

In one aspect, the polymeric reinforcement membrane has an areal density of 5 g/m2 or less, 4 g/m$^2$ or less, 3 g/m$^2$ or less, 2 g/m$^2$ or less or 1 g/m$^2$ or less. In another aspect, the polymeric reinforcement membrane has an areal density range of 5 g/m$^2$ to 0.01 g/m$^2$, 4 g/m$^2$ to 0.1 g/m$^2$, 3 g/m$^2$ to 0.1 g/m$^2$, 2 g/m$^2$ to 0.1 g/m$^2$, 4 g/m$^2$ to 0.2 g/m$^2$, or 3 g/m$^2$ to 0.2 g/m$^2$.

In another aspect, the polymeric reinforcement membrane has a thickness of 1 cm or less, 0.5 cm or less, 0.1 cm or less, or 0.01 cm or less. In another aspect, the polymeric reinforcement membrane has a thickness of at least 0.05 $\mu$m, at least 0.1 $\mu$m or at least 0.2 $\mu$m. In another aspect, the polymeric reinforcement membrane has a thickness range of 0.5 cm to 0.05 $\mu$m, 5 mm to 0.05 $\mu$m, 1 mm to 0.05 $\mu$m, 500 $\mu$m to 0.05 $\mu$m, 100 $\mu$m to 0.05 $\mu$m, 50 $\mu$m to 0.05 $\mu$m, 40 $\mu$m to 0.05 $\mu$m, 30 $\mu$m to 0.05 $\mu$m, 20 $\mu$m to 0.05 $\mu$m, 15 $\mu$m to 0.05 $\mu$m, 40 $\mu$m to 0.1 $\mu$m, 30 $\mu$m to 0.1 $\mu$m, 20 $\mu$m to 0.1 $\mu$m, 20 $\mu$m to 0.1 $\mu$m, 15 $\mu$m to 0.1 $\mu$m, 10 $\mu$m to 0.1 $\mu$m, 40 $\mu$m to 0.2 $\mu$m, 30 $\mu$m to 0.2 $\mu$m, 20 $\mu$m to 0.2 $\mu$m or 10 $\mu$m to 0.2 $\mu$m.

The polymeric reinforcement membrane (prior to coating or imbibing) has a porosity of at least 30%, at least 40%, at least 50%, at least 60%, at least 70% or at least 80%. In one embodiment, the polymeric reinforcement membrane has a porosity range of 50% to 98%, 50% to 95%, 50% to 90%, or 50% to 85%.

The polymeric reinforcement membrane has a matrix tensile strength (MTS) in both the machine direction (MD) and the transverse direction (TD) (orthogonal to the MD) at least about 30 MPa, of at least about 50 MPa, of at least about 100 MPa, of at least about 150 MPa, of at least about 200 MPa or of at least about 300 MPa. In terms of matrix tensile strength, the polymeric reinforcement membrane may be unbalanced (strength in one direction significantly different from the strength in the orthogonal direction) or balanced (strength in MD and TD similar). In another embodiment, the polymeric reinforcement membrane has a ratio of the matrix tensile strength determined as MD:TD from about 0.1: 1.0 to 1.0: 0.1, or from about 0.5:1.0 to 1.0:0.5, or from about 0.7:1.0 to 1.0:0.7.

In a preferred aspect, the polymeric reinforcement membrane is a structured (also referred to herein as a "compacted") membrane. Briefly, the polymeric reinforcement membrane subjected to compaction forms macro-structured folds and/or micro-folded fibrils in the membrane, giving the polymeric reinforcement membrane low modulus and flexibility. The compacted polymeric reinforcement membrane may also or alternatively demonstrate out-of-plane geometries such as wrinkles or folds ("buckles") in the membrane, such as, but not limited to, the methods described in EP3061598 A1 to Zaggl et al. and US Patent No. 9,849,629 to Zaggl, et al. It is to be noted that heat shrinkage or solvent shrinkage or other suitable method may alternatively be used to non-mechanically "compact" the polymeric reinforcement membrane.

The "buckles" or out-of-plane structures in the membrane may have a height that is at least two times the thickness of the non-compacted membrane. In addition, the height of the out-of-plane (i.e. z-direction) structures may range from about 2 $\mu$m to about 2000 $\mu$m or from about 20 $\mu$m to about 1000 $\mu$m. Further, the structure density in at least one direction is at least 1 buckle per mm, at least 2 buckles per mm, at least 3 buckles per mm, at least 4 buckles per mm, at least 5 buckles per mm, at least 6 buckles per mm, at least 7 buckles per mm, at least 8 buckles per mm, at least 9 buckles per mm, or at least 10 buckles per mm. In some embodiments, the structure density is from 1 buckle per mm to 10 buckles per mm, from 1 buckle per mm to 7 buckles per mm, from 1 buckle per mm to 5 buckles per mm, or from 1 buckle per mm to 3 buckles per mm.

In an alternative embodiment taught in, WO2016/135188 to Zaggl et al. a porous membrane having a node a fibril structure may be compressed such that there is little or no introduction of a substantial structure in the "z" direction (i.e., fibril compaction within the node and fibril structure).

**Ferroelectric Materials**

The polymeric reinforcement membrane may be used to form composite films supporting a variety of ferroelectric materials such a ferroelectric polymers, ferroelectric ceramics, and combinations thereof. In one aspect, the ferroelectric polymers may include ferroelectric copolymers (such as poly(vinylidene fluoride-trifluoroethylene)(VDF-TrFE)) and ferroelectric terpolymers (such as poly(vinylidene fluoride-trifluoroethylene-chlorofluoroethylene)(VDF-TrFE-CFE); poly(vinylidene fluoride-trifluoroethylene-chlorotrifluoroethylene)( P(VDF-TrFE-CTFE)), and combinations thereof. In one aspect, the ferroelectric polymers are poly (vinylidene fluoride-co-trifluoroethylene) (for example, SOLVENE® 250/P300; Solvay SA Corp., Brussels, Belgium; approximate 75 mol% VDF and 25 mol% TFE), poly(vinylidene fluoride-trifluoroethylene-chlorofluoroethylene) terpolymer p(VDF-TrFE-CTFE) (for example, SOLVENE® T; approximately 63 mol% VDF, 28 mol% TrFE, and 9 mol% CTFE), and combinations thereof.

Non-limiting examples include quenched thermal evaporation, vapor deposition, spray coating, slot die coating, knife-over-roll coating, Mayer bar coating, gravure printing, screen printing, and roller coating. The ferroelectric material may have a thickness from about 1 nm to about 20 $\mu$m, from about 1 nm to about 15 $\mu$m, from about 1 nm to about 10 $\mu$m, or from about 1 nm to about 5 $\mu$m.

The ferroelectric material is partially or fully distributed on either surface of the polymeric reinforcement membrane. In one aspect, the ferroelectric material is partially or fully distributed on either surface of the compacted/structured polymeric reinforcement membrane. Additionally, the ferroelectric material may be applied in such a manner that the material forms a pattern (e.g., circles, squares, lines, or grids) on the surface of the polymeric reinforcement membrane. In some embodiments, the ferroelectric material forms a monolithic (e.g., continuous) coating on the surface. In another embodiment, the ferroelectric material at least partially penetrates the thickness of the polymeric reinforcement membrane. The depth of penetration may be substantially the same throughout the polymeric reinforcement membrane. In some embodiments, though, the partial penetration depth varies in the porous polymeric reinforcement membrane. The porosity of the polymeric reinforcement membrane facilitates the penetration of the ferroelectric material into the membrane. In a preferred aspect, the ferroelectric material is poly (vinylidene fluoride-co-trifluoroethylene) copolymer, poly (vinylidene fluoride-trifluoroethylene-chlorotrifluoroethylene) terpolymer or a combination thereof and the polymeric reinforcement membrane is an expanded PTFE membrane having a microstructure formed primarily of fibrils or nodes interconnected by fibrils.

The polymeric reinforcement membrane may be used to support particulate ferroelectric materials such as ferroelectric ceramics. The ferroelectric ceramics may include, for example, barium strontium titanate (BST), barium zirconium titanate (BZT), PZT (lead, zirconium, titanium, oxygen), $PbTiO_3$ (PT), $Pb(Mg_{1/3}Nb_{2/3})O_3$ (PMN), $Pb(Mg_{1/3}Nb_{2/3})$

$O_3$-PbTiO$_3$ (PMN-PT), LiTaO$_3$, or a combination thereof. The ferroelectric ceramics may come in a variety of particulate form factors such as nanoparticles, nanowires, nanorods, nanocubes, nanofillers, or a combination thereof. The ferroelectric particles may be added as a filler when forming the fibrillated polymeric reinforcement membrane, applied as a coating or a combination thereof. The ferroelectric material may be applied to the polymeric reinforcement membrane by known deposition and coating methods.

The polymeric reinforcement membrane may be used to form composites comprising one or more ferroelectric polymers and one or more ferroelectric ceramic particles. In one embodiment, the ferroelectric polymer(s) and the ferroelectric ceramics may be combined with the polymeric reinforcement membrane separately or may be combined and applied simultaneous to the polymeric support membrane. In another embodiment, the ferroelectric ceramic particles are present as a filler within the fibrillated (preferably expanded PTFE) polymeric reinforcement membrane to which a ferroelectric polymer and/or a mixture of ferroelectric polymer/ferroelectric ceramic particles is subsequently applied (coating/imbibed).

**Electrodes for Ferroelectric Articles**

Electroactive devices (i.e., sensors, actuators, etc.) are typically stimulated by application of an electrical field. The present ferroelectric articles are comprised of a composite film of a ferroelectric material on a polymeric support and at least 2 electrodes to provide the electrical field. Electrically, the present ferroelectric articles act as a capacitive device, with an insulating dielectric polymeric film of thickness "d" typically in the range of 2 -25 $\mu$m and a relative permittivity number $\varepsilon_r$ in the range of 10 up to 55 F·m$^{-1}$. The film itself is considered as a thin and highly polar VDF-based copolymer and/or terpolymer composite film reinforced by a thin nonpolar membrane (for example, ePTFE). Two electrodes with an area ("A") are applied to the composite film to provide the electrical field.

The capacitance is defined by the geometry factor (A/d) magnified by the relative permittivity number $\varepsilon_r$ of the composite film. An electrical field polarizes the VDF-based composite film, i.e. orienting the dipoles along the VDF molecular chan. Therefore, two electrodes with an area A are needed to build up the necessary electrical field. Depending on the application and design specification, the electrodes of an may be patterned in different shapes (i.e., rectangular, circular and or comb structure). In general, the electrodes are comprised of thin films of conductive metals (such as Ag, Au, and Al), conductive polymers (such as poly(3,4-ethylenedioxythiophene) polystyrene sulfonate (PDOT:PSS)), conductive metal oxides (such as indium tin oxide (ITO)), conductive silver nano particles/wires, or any combinations thereof.

There are a variety of techniques available to apply the conductive material to the target substrate including, but not limit to:

- resistive heating of metal (e.g., Al, Ag, Au, etc.) in a vacuum chamber on cooled substrate;

- magnetron sputtering of metal (e.g., Au) in a vacuum chamber on a cooled substrate (for example, magnetron sputtering of Au using a current = 60 mA for 30 seconds; 2 layers);

- screen printing of conductive polymers and/or conductive silver nano particles inks;

- digital printing of conductive silver nano particles inks; and

- spraying via shadow mask with conductive silver nano particles/wire inks.

As exemplified herein, thin aluminum electrodes were deposited to the composite film by resistive heating in a vacuum chamber at a typical pressure lower than 10-3 mbar. The composite film was aligned and fixed on a polyethylene terephthalate/biaxially oriented polypropylene (PET/BOPP) liner having a thickness typically between 25 $\mu$m up to 50 $\mu$m. The composite film was then exposed to the metal vapor. The composite film was cooled down to typically -30°C during the metal deposition. This process, known as quenched deposition, allows a temperature profile across the composite film far below the melting temperature of the composite films. The deposition is carried out by a roll-to-roll process, enabling a certain length of a homogeneous metal to be coated with minimal thickness variability. For rectangular patterning, no shadow-mask is needed. The width of deposition is controlled by two mechanical shutter frames placed very close to the substrate. If a pattern is required (for example, a circular electrode), a shadow-mask (made of a material such as PET) with the required pattern design is prepared by laser cutting. This patterned shadow-mask is positioned on the surface of the composite film.

The thickness of metal deposition is controlled by the resistive heating power, the time of deposition and online monitored by a quartz micro balance and/or an optical density monitor. After the first deposition the chamber is pressured by nitrogen gas and the EAP composite film is carefully flipped to the opposite face for the backside electrode. The shadow mask is transferred too and carefully aligned.

As exemplified herein, circular aluminum patterned electrodes were deposited on both faces of the thin composite film. The circular patterned electrodes had diameters from 25.4 mm down to a quarter of an inch. The thickness of deposited aluminum film was 85 $\mu$m $\pm$ 5 $\mu$m, resulting in a surface conductivity of 3 -4 $\Omega$.

While measuring the overall single capacitance value and knowing the entire film thickness, one may calculate the relative permittivity number by

$$\varepsilon_r = \frac{C_{Sample} \cdot d_{film}}{\varepsilon_0 \cdot A}$$

where $C_{Sample}$ is the capacitance of the test sample (in farads; (F)), $d_{film}$ is the thickness of dielectric material (i.e. distance between both electrodes) in meters (m), $\varepsilon_0$ is the absolute permittivity in (F/m), and A is the surface area of the capacitor (m$^2$).

## Balancing Annealing with Mechanical Properties

It is desirable to maximize the crystallinity of VDF copolymer films to maximize the piezoelectric response. This can be accomplished by a variety of annealing methods, including the steps of melting the VDF copolymer and recrystallizing it by cooling it slowly to promote crystal nucleation and growth. However, an increase in crystallinity can make monolithic VDF copolymer films brittle, decreasing the ductility and toughness. As demonstrated herein, reinforcing the VDF copolymers with the present polymeric membranes (such as ePTFE) can significantly improve the mechanical toughness after such an annealing process.

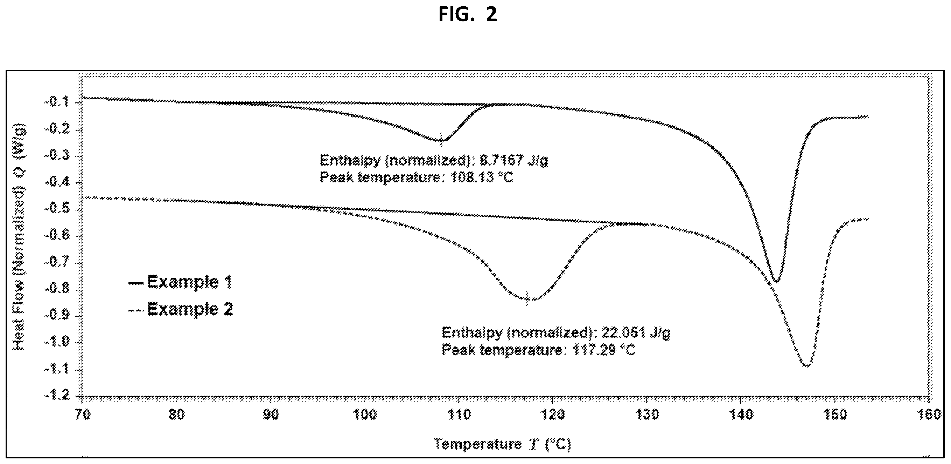

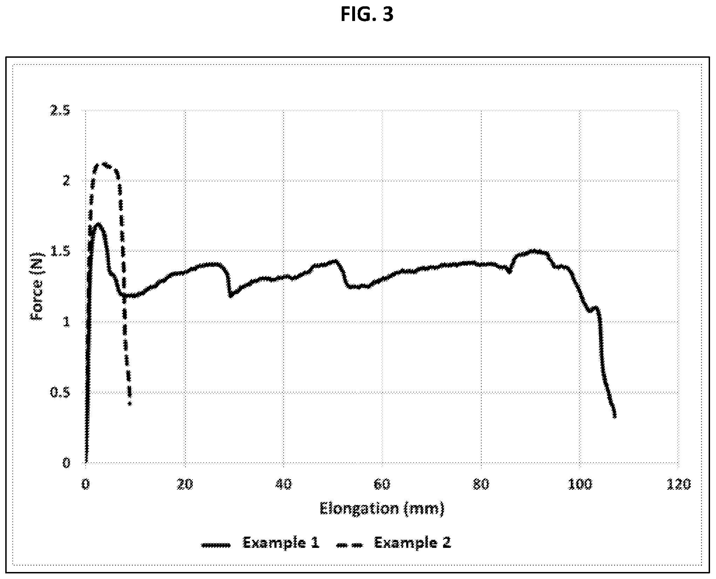

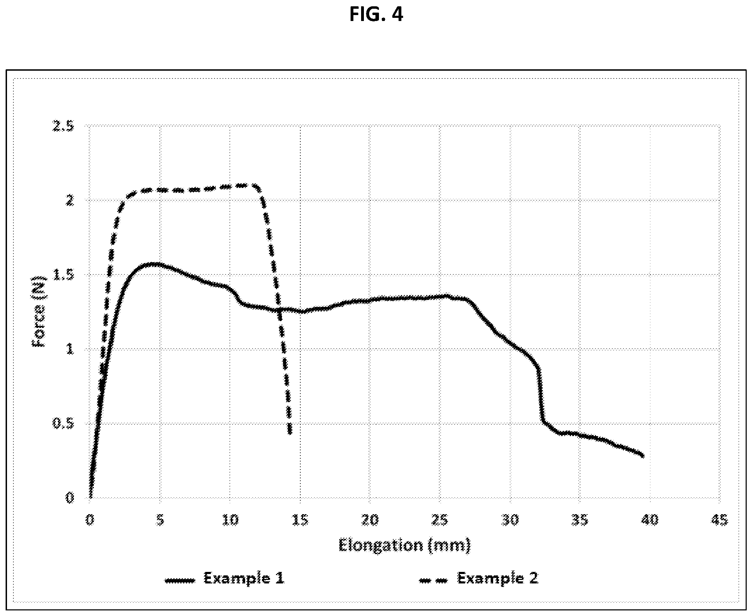

The relative crystallinity of films can be determined by DSC measurements. The enthalpy of the solid-state transition between the ordered and disorder structure of the crystalline phase is directly related to the crystallinity. As shown in Figure 2, annealing the monolithic film increased the DSC enthalpy relative to the non-anneal monolithic film (Example 1 vs. Example 2; Table 1). The enthalpy is approximately 2.4X larger for the sample held at 155 ∘C and slowly cooled compared to the film which is not annealed. This indicates that the crystallinity is approximately 2.4 times larger. However, the ductility and mechanical toughness of the annealed monolithic film is significantly decreased due to the increase in crystallinity, as shown Figures 3 and 4.

Reinforcement of the VDF-TrFE copolymer with the present membrane can improve the toughness after the annealing process. Turning to Table 1, the effect of annealing on the present reinforced composites increased the DSC enthalpy (approximately 2.5X) for VDF copolymer (comparing Example 3 vs. Example 4) and provided improved mechanical performance using ePTFE membrane 1 (an ePTFE membrane having more strength in the machine direction relative to the transverse direction). The DSC enthalpy and mechanical performance of a reinforced composite using an ePTFE membrane having a more balanced strength profile (i.e. ePTFE membrane 2) is provided in Table 1, comparing Example 5 vs. Example 6. Annealing increased crystallinity (approximately 2.8X) and balanced mechanical performance in both the machine and transverse directions was observed.

## TEST METHODS

## Scanning Electron Microscope (SEM) - Cross-Section Sample Preparation and Imaging

SEM images were collected using a Field Emission Scanning Electron Microscope (ZEISS Gemini SEM 500, Zeiss International, Oberkochen, Germany). Cross-sectioned samples were prepared using a cooled straight-razor blade method and mounted onto a 12.5 mm diameter metal stub with carbon double-sided adhesive pads (SpectroTabs, Plano GmbH, Wetzlar Germany). The mounted samples were sputter-coated with platinum.

## Thickness Measurement

The thickness of the films was determined from the SEM images of the cross-sections.

## Mass per Area/Composition Measurement

The mass per area was determined by measuring the mass of a circle with a diameter of 80 mm that was cut from the film. The composition, i.e., the mass fraction of the electroactive VDF copolymer or terpolymer in the film, was determined from the ratio of the laydown of the VDF copolymer or terpolymer in the coating process to the measured mass per area of the film.

**Mechanical Tensile Test**

Static and dynamic mechanical tensile tests were conducted on a Z050 Universal Testing Machine (ZwickRoell GmbH & Co. KG, Ulm, Germany) with a load cell of 200N and controlled by the instrument manufacturer's software (testXpert III) using default parameters set by the manufacturer unless otherwise noted (ZwickRoell, *supra*).

Briefly, rectangular samples with dimensions of (25.4 x 5) mm were prepared with a cutting tool and placed between the clamping mechanism by a sample loading tool from the outside. A pre-force of 0.01 N and a constant linear draw rate of 200 mm/min were used for the static tension measurements. The tests were conducted at a room temperature (approximately 21°C).

The dynamic test was performed with the same testing machine and similar samples dimensions A cycling procedure with 10 repetitive cycles of a periodic trapezoidal force loading was applied to the specimen. The set-up was accomplished by a flexible programming language ZIMT (ZwickRoell Interpreter for Materials Testing, ZwickRoell, *supra).* An overall 1.5 % range of elongation within the elastic region was chosen to acquire data of the periodic force

**Differential Scanning Calorimetry (DSC) Measurement**

DSC data were collected using a TA Instruments Q2000 DSC (TA Instruments, New Castle, DE) between -50°C and 155°C using a heating rate of 10 °C/min. A sample with a mass approximately 7 to 8 mg was loaded into the sample holder for the tests. The enthalpy of the solid-state transition was determined by using the integration function included with the software.

**DC- Voltage Breakdown Method**

The test procedure followed ASTM D3755-97 (2004). In this process, greater than 25 individual test points are brought into direct contact between the electrodes consisting of metalized biaxial oriented polypropylene. A 76.2 $\mu$m (3 mil) thick Kapton film with a defined circular hole (or window), featuring a diameter of 0.25 inches, (= 0.635 cm) was placed on top of the test film to constrain location and size of contact area. Contact to the film occurred between the bottom metalized polypropylene film and the top metalized polypropylene film only within the hole found in the Kapton film. An Associated Research Hypot Dielectric Analyzer Model 7720 is used to ramp the voltage at 500V/s until breakdown occurs at which point the voltage is recorded. For data evaluation a continuous probability distribution (Weibull distribution function) is applied.

**Electrical Polarization Method**

A standard AC poling procedure was used as described in literature (Qiu et al., J. Appl. Phys. (2013), 113: 224106-1 to 224106-8. A modified Sawyer-Tower circuit (Qui *et al., supra*) and a combination of unipolar and bipolar voltage waveforms are employed to record hysteresis curves on VDF-based co-/terpolymer composite film polarization versus electric field. Hysteresis is an essential feature of a ferroelectric material and may also be used for determining some of its main properties.

**$d_{33}$ Measuring Station**

The piezoelectric coefficient, $d_{33}$, was measured according to the Berlincourt method (Stewart M., Cain M.G. (2014) Direct Piezoelectric Measurement: The Berlincourt Method. In: Characterisation of Ferroelectric Bulk Materials and Thin Films. Springer Series in Measurement Science and Technology, vol 2., Cain, M (editor), Springer, Dordrecht. To determine the piezoelectric coefficient $d_{33}$ in the thickness direction, the sample is placed under an electrodynamic shaker and applied with a static force of 3 N. The shaker oscillates at 2 Hz and exerts a sinusoidal force with an amplitude of 1 N. The electrical charges generated by the piezoelectric effect of the sample are amplified by a charge amplifier and displayed on an oscilloscope. The dynamic force is measured by a force sensor and displayed on the oscilloscope. Using both curves, the piezoelectric coefficient was determined from the quotient of the charge signal and the dynamic force. The piezoelectric coefficient $d_{33}$ was also determined using a commercially available Piezo meter system ($d_{33}$ PiezoMeter System Model PM300, Piezotest Pte. Ltd., Singapore) that applies the Berlincourt method. Briefly, a test sample is clamped in the system and subjected a low frequency force. Processing of the electrical signals from the sample, and comparison with a built-in reference, enables the system to give a direct reading of $d_{33}$.

**Expanded polytetrafluoroethylene (ePTFE) Membranes**

The following ePTFE membranes were used in the present examples. **"ePTFE Membrane 1"** - Preparation ePTFE Membrane

An ePTFE membrane was manufactured according to the general teachings set forth in U.S. Patent No. 5,476,589 to Bacino. The ePTFE membrane is similar to "ePTFE Membrane 3" (below) but with a higher areal density (mass-per-area) of approximately 3 g/m$^2$.

**"ePTFE Membrane 2"** - Preparation ePTFE Membrane

An ePTFE membrane was manufactured according to the general teachings set forth in U.S. Patent No. 7,306,729 to Bacino et al. The ePTFE membrane had a mass-per-area of approximately 3.8 g/m$^2$, a non-contact thickness of approximately 14.2 $\mu$m, a bubble point of approximately 481 kPa, a matrix tensile strength of approximately 343 MPa in the machine direction, and a matrix tensile strength of approximately 268 MPa in the transverse direction.

**"ePTFE Membrane 3"** - Preparation ePTFE Membrane

An ePTFE membrane was manufactured according to the general teachings set forth in U.S. Patent No. 5,476,589 to Bacino. The ePTFE membrane had a mass-per-area of approximately 2.1 g/m$^2$, a non-contact thickness of approximately 7.4 $\mu$m, a bubble point of approximately 271 kPa, a matrix tensile strength of 1058 MPa in the machine direction, and a matrix tensile strength of approximately 93.6 MPa in the transverse direction

**"ePTFE Membrane 4"** - Preparation of Structured ePTFE Membrane

An ePTFE membrane was manufactured according to the general teachings set in U.S. Patent No. 7,306,729 to Bacino et al. The ePTFE membrane had a mass-per-area of approximately 0.2 g/m$^2$, a non-contact thickness of approximately 1 $\mu$m, a bubble point of approximately 407 kPa, a matrix tensile strength of 734 MPa in the machine direction, and a matrix tensile strength of approximately 755 MPa in the transverse direction.
The ePTFE membrane was structured uniaxially in the transverse direction by a ratio of 1 to 1.5 according to the teaching set in U.S. Patent No. 9,849,629 to Zaggl et al. After the structuring the compacted membrane was transferred to the imbibing process.

**Piezo- and Ferroelectric Polymers**

The following polymer resins were used in the present examples. poly (vinylidene fluoride-*co*-trifluoroethylene)
A poly (vinylidene fluoride-co-trifluoroethylene) copolymer having piezo-, pyro- and ferroelectric properties was used (SOLVENE® 250/P300; Solvay SA Corp. Brussels, Belgium; CAS Number 28960-88-5). The resin is comprised of approximately 75 mol% VDF and 25 mol% TrFE. The SOLVENE® 250/P300 P(VDF-TrFE) copolymer has the following properties:

| | |
|---|---|
| Melting temperature | 146 °C |
| Average molecular weight: | 300 kDa (1 kDa = 1000 g/mol) |
| Modulus | 1000 MPa |
| Curie temperature: | 116 °C |
| Crystallization temperature: | 120 °C |
| Density (film): | 1.7 g/cm$^3$ |
| $\varepsilon_r$ (25 °C; 1kHz): | 11 F·m$^{-1}$ |
| Breakdown Voltage: | > 280 V/$\mu$m |
| Piezoelectric coefficient ($d_{33}$): | -24 pC/N at 110Hz |

poly (vinylidene fluoride-trifluoroethylene-chlorotrifluoroethylene) terpolymer

A poly (vinylidene fluoride-trifluoroethylene-chlorofluoroethylene) terpolymer p(VDF-TrFE-CTFE) (SOLVENE® T EAP; Solvay SA Corp., Brussels, Belgium) was used. The terpolymer is approximately 63 mol% VDF, 28 mol% TrFE, and 9 mol% CTFE. The p(VDF-TrFE-CTFE) terpolymer is a ferrorelaxor polymer with a high dielectric constant. The p(VDF-TrFE-CTFE) terpolymer has the following properties:

| | |
|---|---|
| Melting temperature: | 115 °C |
| Average molecular weight: | 300 kDa |

(continued)

| | |
|---|---|
| Modulus: | 200 MPa |
| Crystallization temperature: | 85∘C |
| Curie temperature: | 16∘C |
| Density (film): | 1.7 g/cm$^3$ |
| Breakdown Voltage: | > 300 V/$\mu$m |
| $\varepsilon_r$ (25 ∘C; 1kHz) | 45 F·m$^{-1}$ |

## Applying Electrodes to Composite Films

Thin Aluminum electrodes (round, 15 mm in diameter) were deposited by resistive heating in a vacuum chamber at a typical pressure lower than 10$^{-3}$ mbar. The composite film is aligned and fixed on a PET/BOPP liner having a typical thickness between 25 $\mu$m up to 50 $\mu$m. It is then exposed to the metal vapor. The film is cooled down to typically -30°C during the metal deposition. This process, known as quenched deposition, allows a temperature profile across the composite film far below the melting temperature of the composite films. The deposition is carried out by a roll-to-roll process enabling a certain length of a homogeneous metal to be coated with minimal thickness variability. For rectangular patterning, no shadow-mask is needed. The width of deposition is controlled by two mechanical shutter frames placed very close to the substrate. If a pattern is required (e.g., a circular electrode), a shadow-mask (e.g., PET) with the required pattern design is prepared by laser cutting. This patterned shadow-mask is positioned on the surface of the composite film.

The thickness of metal deposition is controlled by the resistive heating power and the time of deposition, and it is monitored online by a quartz micro balance and/or an optical density monitor. After the first deposition, the chamber is pressurized by nitrogen gas and the composite film is carefully flipped to the opposite face to apply the second electrode. The shadow mask is transferred and carefully registered so the two electrodes are aligned. The thickness of deposition is typically in the range of 60-85 nm.

The electrodes were attached to both sides of the samples for the hysteresis measurements. In the corona polarized samples, the electrodes are first applied after the polarization; the method is the same as with the electrodes for the hysteresis measurement.

## EXAMPLES

### EXAMPLE 1

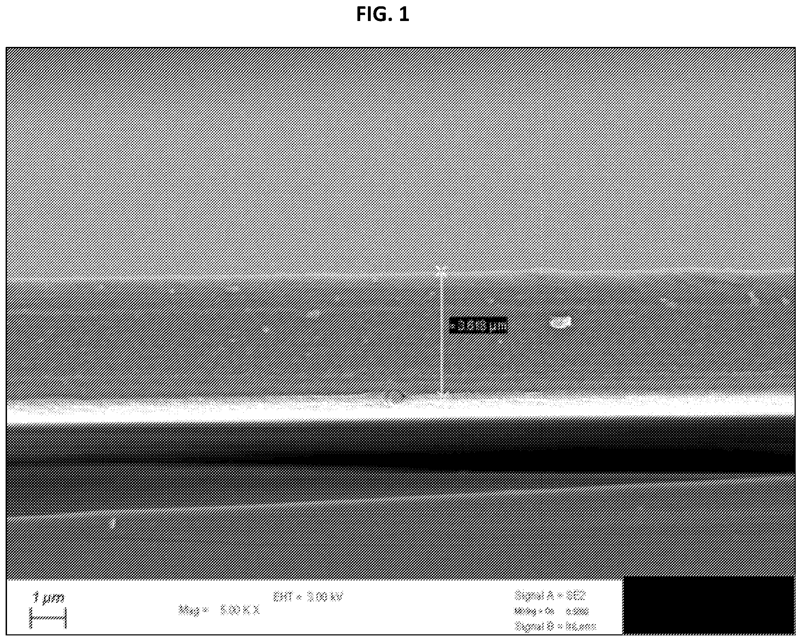

A solution of 10% by weight of poly (vinylidene fluoride-co-trifluoroethylene) copolymer resin (SOLVENE® 250/P300; Solvay SA Corp, *supra)* and methyl ethyl ketone (MEK) was prepared by mixing the components and stirring for 4 hours at room temperature (nominally 24°C). The resulting solution was applied directly to a carrier film with a slot die in a continuous roll-to-roll process. The film was dried to remove the solvent in an in-line oven. A cross-sectional SEM image of the monolithic cast film was collected and is provided as Figure 1. As measured by SEM, the film has a thickness of approximately 3.6 $\mu$m. Differential scanning calorimetry (DSC) analysis was conducted. The DSC plot for the monolithic cast film is provided as Figure 2 (top). The enthalpy of the solid-state crystalline transformation obtained by integration is 8.7167 Joules/gram. Tensile testing (elongation vs. force) was conducting as described under test methods on the monolithic cast film. The tensile testing result in the machine (down-web) direction (MD) for the monolithic cast film is provided in Figure 3 (Example 1, solid line). The tensile testing result in the transverse (cross-web) direction (TD) for the monolithic cast film is provided in Figure 4 (Example 1, solid line). The characterization results for Example 1 are summarized in Table 1.

### EXAMPLE 2

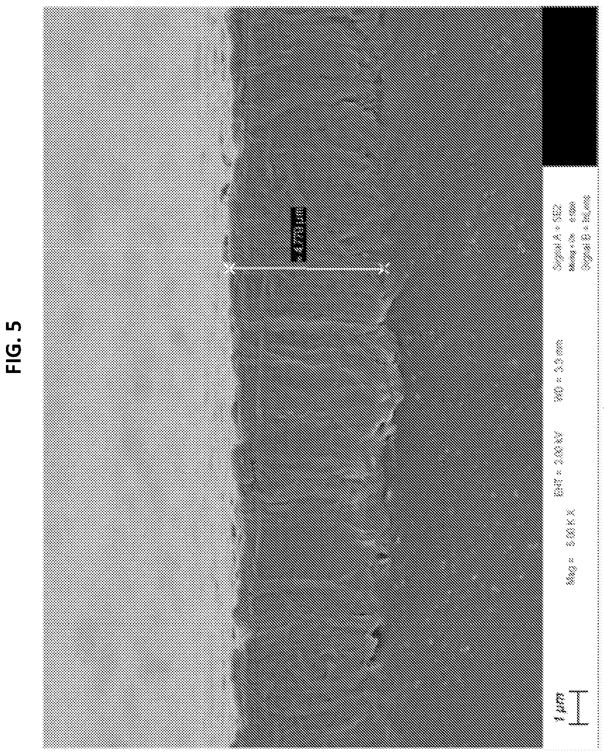

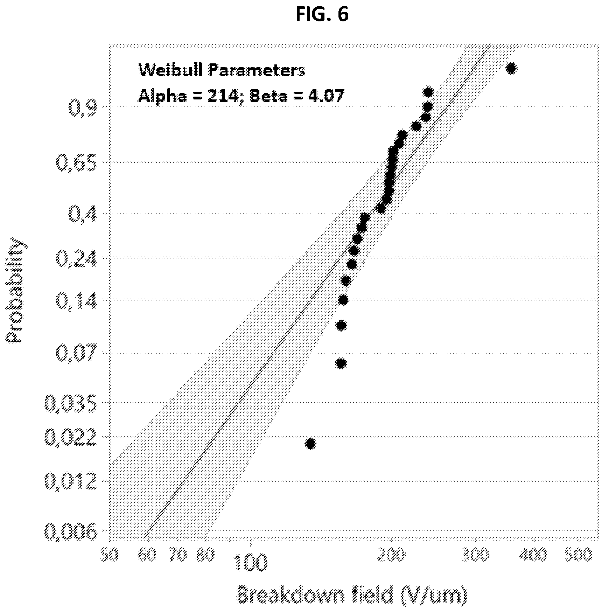

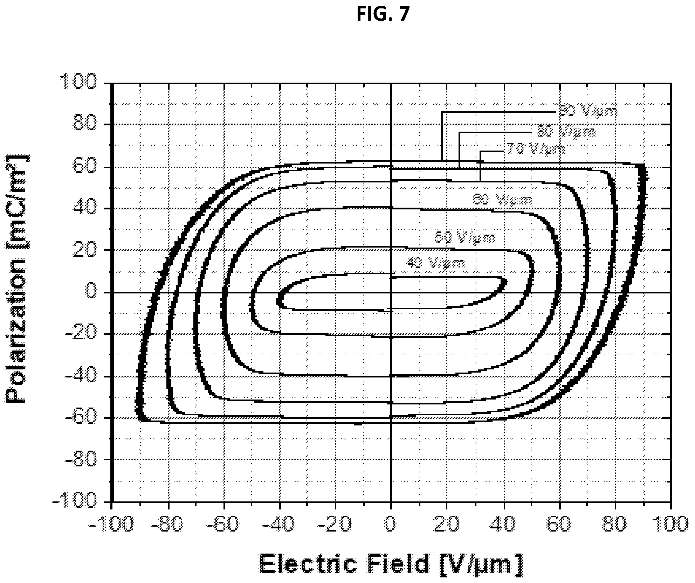

The monolithic film of Example 1 was annealed by placing it in an oven with the temperature set at 155°C for 10 minutes. The power to the oven was then shut off and the film was left in the oven until it reached room temperature (nominally 24 °C), enabling the film to cool slowly. A cross-sectional SEM image of the annealed film is shown in Figure 5 where the annealed film thickness is approximately 4.8 $\mu$m. DSC was conducted on the and the resulting plot is shown in Figure 2 (Example 2, dashed line). The enthalpy of the solid-state crystalline transformation obtained by integration is approximately 22.051 J/g. The ratio of the annealed film enthalpy to the non-annealed monolithic film enthalpy of Example 1 indicates that the annealing process increased the crystallinity of the film by a factor of 2.5. Tensile testing was conducted as described in Example 1 and the plot of elongation vs. force is provided in Figure 3 (machine direction; dashed line) and Figure 4 (transverse direction; dashed line). Voltage breakdown testing was conducted as described above under test methods. The voltage breakdown results are graphically illustrated in the Weibull Plot of Figure 6 where the Weibull parameters alpha and beta were determined. Electrical polarization measurements were conducted as described under test methods. A plot of the polarization results (electric field vs. polarization) is shown in Figure 7. The characterization data are summarized in Table 1.

**EXAMPLE 3**

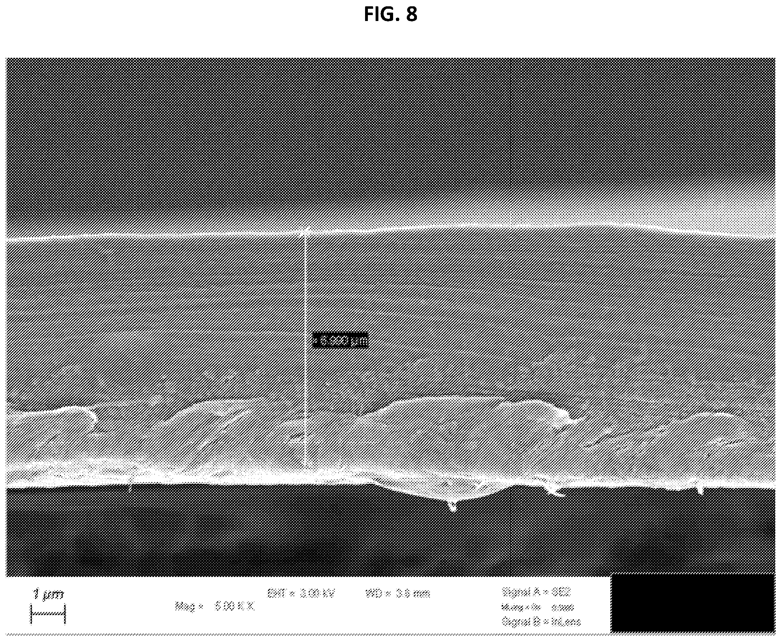

The 10 wt% solution of Example 1 (poly (vinylidene fluoride-co-trifluoroethylene) copolymer resin dissolved in MEK) was applied using a slot die in continuous roll-to-roll process to a microporous ePTFE membrane ("ePTFE Membrane 1"). The solution uniformly wetted and filled the ePTFE membrane. The film was dried to remove the solvent in an in-line oven. The resulting composite film had a composition of 39 wt% poly (vinylidene fluoride-co-trifluoroethylene) copolymer resin and 61 wt% ePTFE. A cross-sectional SEM image of the composite film is shown in Figure 8. DSC analysis was conducted to measure the enthalpy (normalized). Tensile testing was conducted to measure elongation vs force (MD and TD). Voltage breakdown testing was conducted to determine the Weibull parameters alpha and beta. The characterization results are summarized in Table 1.

**EXAMPLE 4**

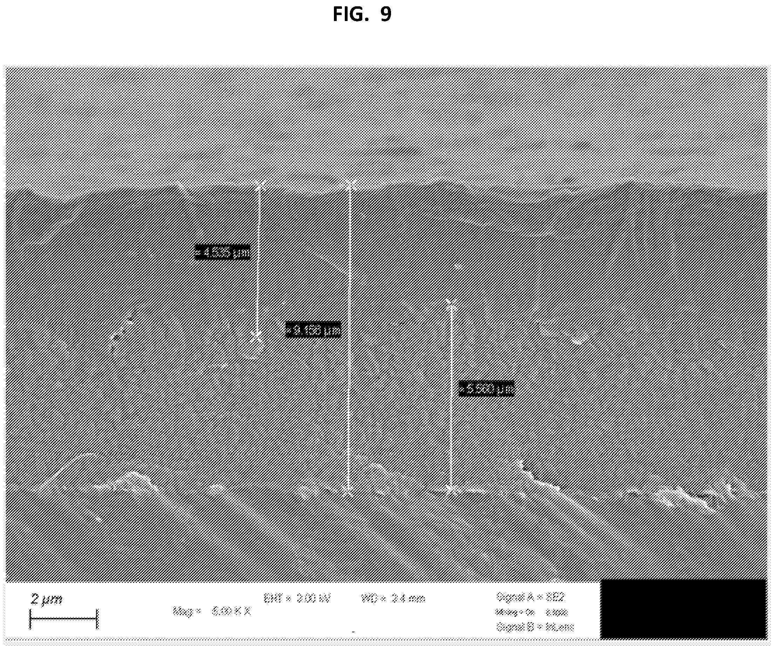

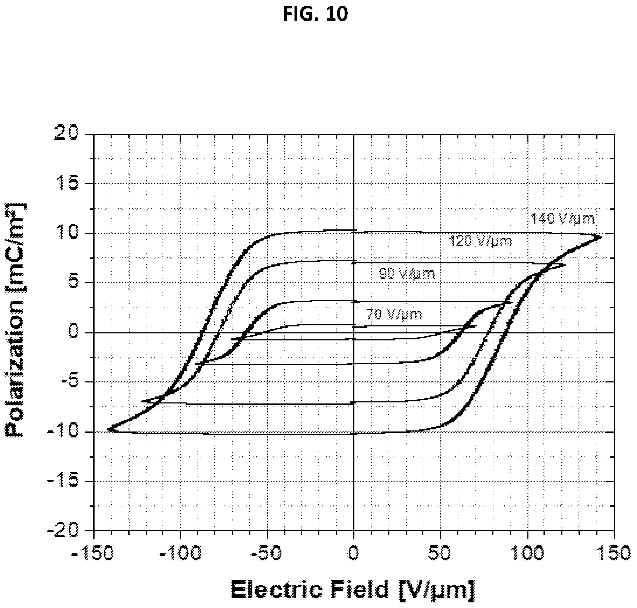

The composite film of Example 3 was annealed by placing it in an oven with the temperature set at 155°C for 10 minutes. The power to the oven was then shut off and the film was left in the oven until it reached room temperature (nominally 24 °C), enabling it to cool slowly. A cross-sectional SEM image of the annealed composite film is shown in Figure 9. DSC analysis was conducted to measure the enthalpy (normalized). Tensile testing was conducted to measure elongation vs force (MD and TD). Voltage breakdown testing was conducted to determine the Weibull parameters alpha and beta. Electrical polarization measurements were conducted and of the polarization results are shown in Figure 10. The characterization data are summarized in Table 1.

**EXAMPLE 5**

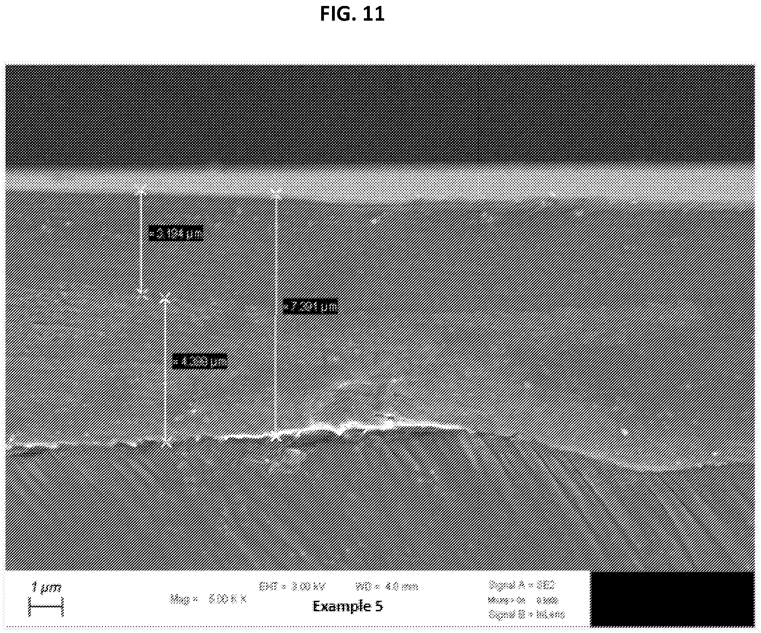

The 10 wt% solution of Example 1 (poly (vinylidene fluoride-co-trifluoroethylene) copolymer resin dissolved in MEK) was applied using a slide die in a continuous roll-to-roll process to directly to a microporous ePTFE membrane ("ePTFE Membrane 2"). The solution uniformly wetted and filled the ePTFE membrane. The film was dried to remove the solvent in an in-line oven. The composite film had a composition of 43 wt% poly (vinylidene fluoride-co-trifluoroethylene) copolymer resin and 57 wt% ePTFE. A cross-sectional SEM image of the composite film is shown in Figure 11.
DSC analysis was conducted to measure the enthalpy (normalized). Tensile testing was conducted to measure elongation vs force (MD and TD). Voltage breakdown testing was conducted to determine the Weibull parameters alpha and beta. The characterization data are summarized in Table 1.

**EXAMPLE 6**

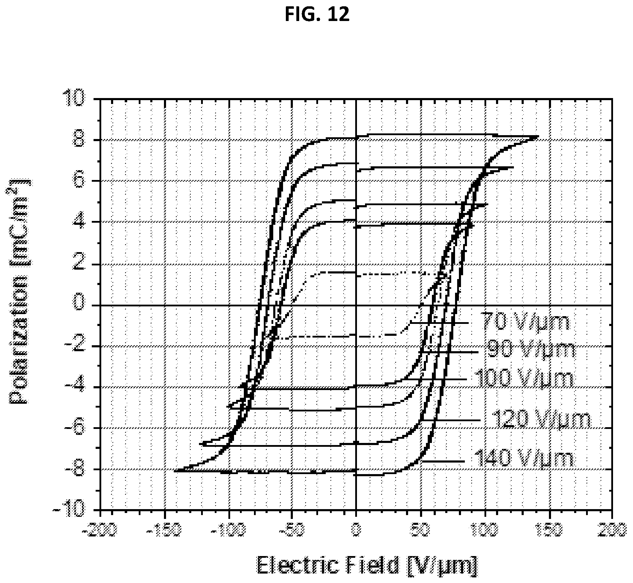

The composite film of Example 5 was annealed by placing it in an oven with the temperature set at 155°C for 10 minutes. The power to the oven was then shut off and the film was left in the oven until it reached room temperature (nominally 24 °C), enabling it to cool slowly.
DSC analysis was conducted to measure the enthalpy (normalized). Tensile testing was conducted to measure elongation vs force (MD and TD). Voltage breakdown testing was conducted to determine the Weibull parameters alpha and beta. Electrical polarization measurements were conducted and of the polarization results are shown in Figure 12. The characterization data are summarized in Table 1.

**EXAMPLE 7**

The following examples describes the preparation of a multilayered VDF-based copolymer films.
A monolithic film of poly (vinylidene fluoride-co-trifluoroethylene) copolymer resin was made using the general process of Example 1. An ePTFE composite film comprising (poly (vinylidene fluoride-co-trifluoroethylene) copolymer resin was made according to Example 5. The multilayering of several VDF-based copolymer films was achieved by two step approach under temperature and high pressure for a certain dwell time. For this purpose, a commercial high-performance heated press (Model P200 S from COLLIN Lab & Pilot Solutions GmbH) was used. The hot plates were heated up to 155 °C and a pressure of 50 bar was applied to the films for adhesion for both process steps.
First, the monolithic film with the ePTFE composite film were stacked and manually aligned. High temperature silicone rubbers sheets (HT60 from Silex Silicone LTD, Hampshire, UK) were used as liners separating the stacked films from the hot plates to prevent surface irregularities between the polymer stack and the hot plates. The arranged stacked was then compressed between the hot plates for 30 minutes at 155 °C at 50 bar. The heated press was opened, and the two-layer bonded stack was allowed to slowly cool.

Next, one of the silicone liners was manually removed from one side of the two-layer stack and a third layer (a monolithic film of poly (vinylidene fluoride-co-trifluoroethylene) copolymer resin; Example 1) was placed onto the VDF-based surface of the two-layer stack. Once again, a silicone liner was used to separate the stacked sheets from the hot plate surface. The 3-layer stack was compressed together for using the same process parameters (30 minutes at 155 °C and 50 bar).

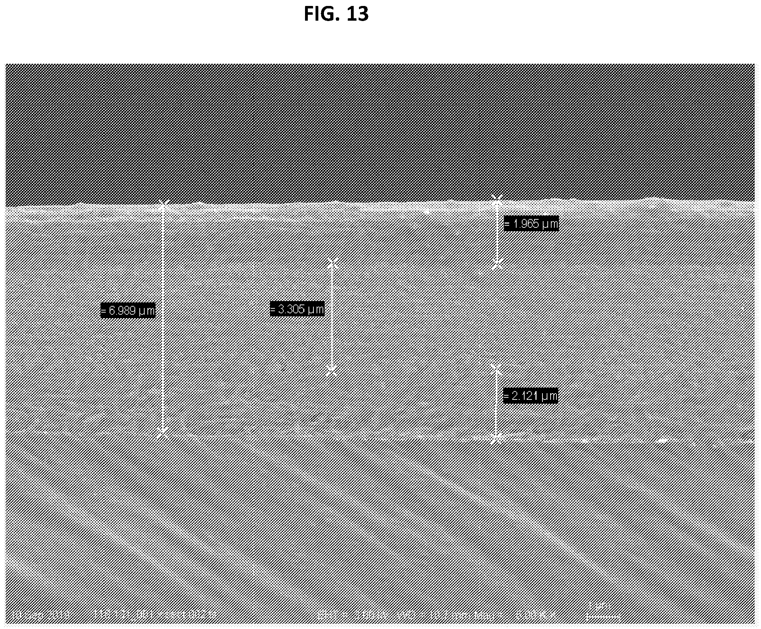

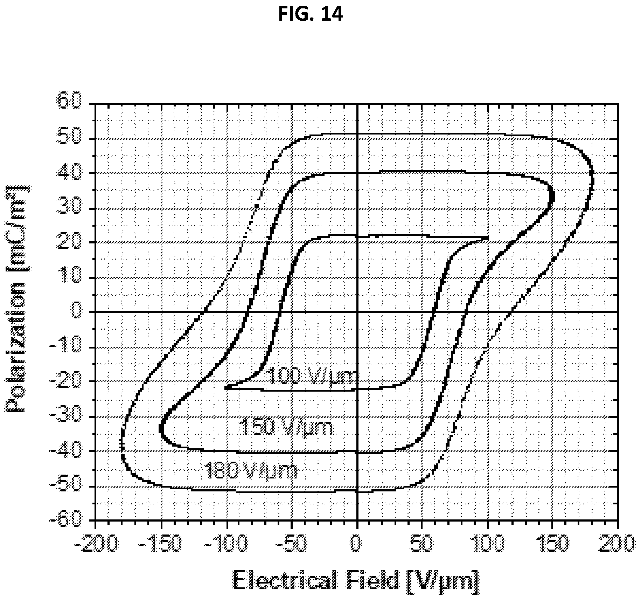

The resulting multi-layered composite film had a composition of 71 wt% poly (vinylidene fluoride-co-trifluoroethylene) copolymer resin (SOLVENE® 250/P300) and 19 wt% ePTFE. A cross-sectional SEM image of the 3-layer film is shown in Figure 13. The results of polarization experiments are shown in Figure 14. The characterization data are summarized in Table 1.

### EXAMPLE 8

A solution of 10% by weight poly (vinylidene fluoride-trifluoroethylene-chlorofluoroethylene) terpolymer p(VDF-TrFE-CTFE) (SOLVENE® T resin, Solvay SA Corp., *supra)* and methyl ethyl ketone was prepared by mixing the components and stirring for 4 hours at room temperature (nominally 24°C). The solution was applied using a slot die in a continuous roll-to-roll process to a microporous ePTFE membrane ("ePTFE Membrane 2"). The solution uniformly wetted and filled the ePTFE membrane. The film was dried to remove the solvent in an in-line oven. The resulting composite film had a composition of 53 wt. % p(VDF-TrFE-CTFE) (SOLVENE® T) and 47 wt. % ePTFE. The composite film was annealed by placing it in an oven with the temperature set at 125°C for 10 minutes. The power to the oven was then shut off and the film was left in the oven to slowly cool over approximately 24 hours until it reached room temperature (nominally 24 °C).

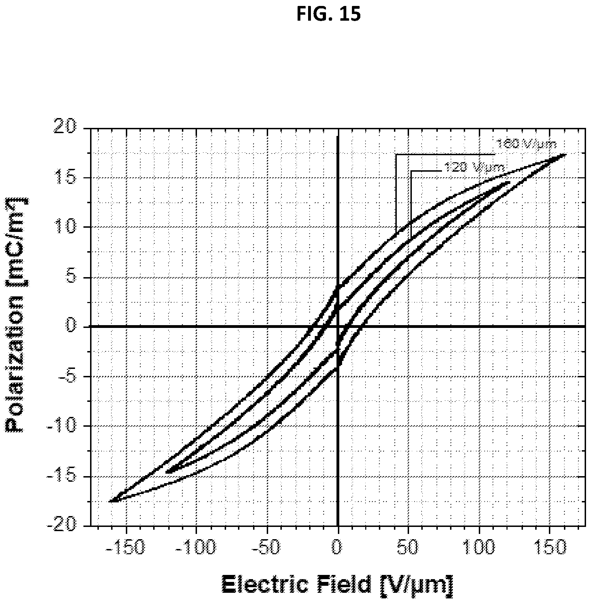

Cross-sectional SEM image analysis was used to determine composite film thickness. DSC analysis was conducted to measure the enthalpy (normalized). Voltage breakdown testing was conducted to determine the Weibull parameters alpha and beta. Electrical polarization measurements were conducted and of the polarization results are shown in Figure 15. The characterization data are summarized in Table 1.

### EXAMPLE 9

A 10 wt% solution of poly (vinylidene fluoride-trifluoroethylene-chlorofluoroethylene) terpolymer p(VDF-TrFE-CTFE) (SOLVENE® T resin, Solvay SA Corp, supra) was prepared and applied to an ePTFE as described in Example 8 except that the ePTFE membrane used was "ePTFE Membrane 3". The solution uniformly wetted and filled the ePTFE membrane. The film was dried to remove the solvent in an in-line oven. The resulting composite film had a composition of 52 wt. % p(VDF-TrFE-CTFE) (SOLVENE® T) and 48 wt. % ePTFE. The composite film was annealed by placing it in an oven with the temperature set at 125°C for 10 minutes. The power to the oven was then shut off and the film was left in the oven to slowly cool over approximately 24 hours until it reached room temperature (nominally 24 °C).

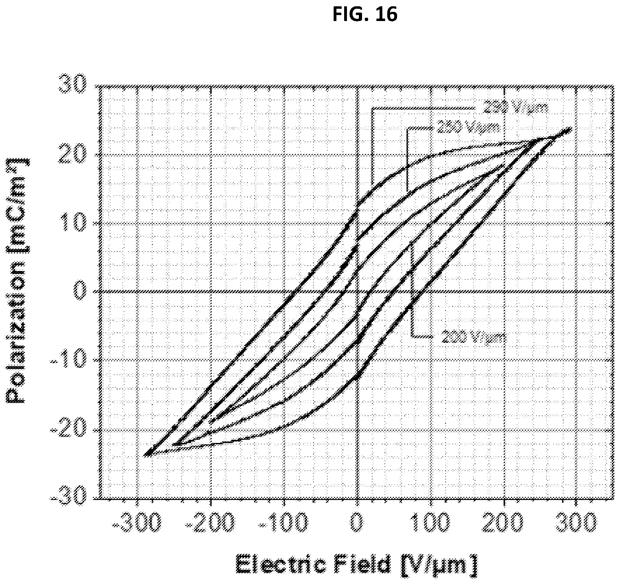

Cross-sectional SEM image analysis was used to determine composite film thickness. DSC analysis was conducted to measure the enthalphy (normalized). Voltage breakdown testing was conducted to determine the Weibull parameters alpha and beta. Electrical polarization measurements were conducted and of the polarization results are shown in Figure 16. The characterization data are summarized in Table 2.

### EXAMPLE 10

Example 10 was processed in two steps. A microporous PTFE membrane ("ePTFE Membrane 4") was structured uniaxially in the transverse direction by a ratio of (1.0:1.5) as described by the teachings set in U.S. Patent No. 9,849,629 to Zaggl et al. A solution of 10 % by weight p(VDF-TrFE-CTFE) (SOLVENE® T resin, Solvay, *supra)* and methyl ethyl ketone was prepared by mixing the components and stirring for 4 hours at room temperature (nominally 24°C). The solution was applied using a slot die a continuous roll-to-roll process to the structured microporous PTFE membrane. The composite film was annealed by placing it in an oven with the temperature set at 125°C for 10 minutes. The power to the oven was then shut off and the film was left in the oven to slowly cool for approximately 24 hours until it reached room temperature (nominally 24 °C). The resulting composite film had a composition of 84 wt. % of the VDF-based terpolymer and 16 wt. % ePTFE.

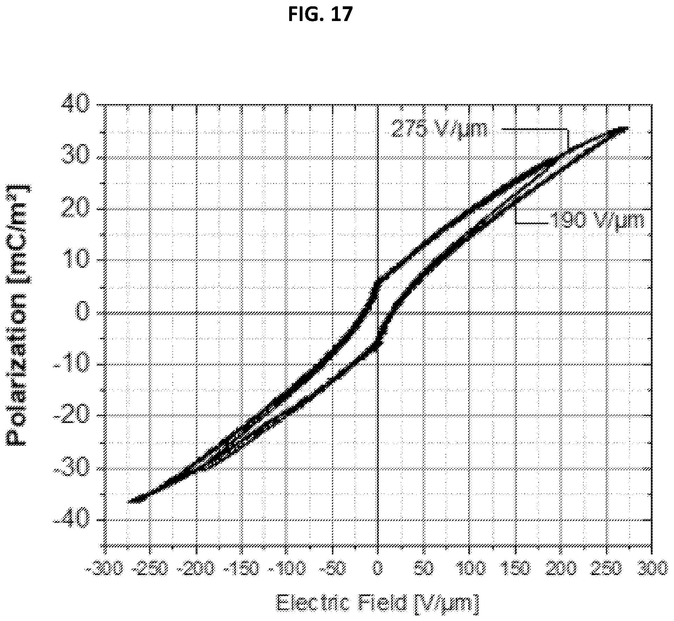

Cross-sectional SEM image analysis was used to determine composite film thickness. Electrical polarization measurements were conducted and of the polarization results are shown in Figure 17. The characterization data are summarized in Table 2.

## EXAMPLE 11

EXAMPLE 11 was processed in two steps. A structured microporous PTFE membrane was prepared as described in Example 10. A solution of 10 % by weight p(VDF-TrFE-CTFE) (SOLVENE® T resin, Solvay, *supra)* and methyl ethyl ketone prepared by mixing the components and stirring for 4 hours at room temperature (nominally 24°C). The p(VDF-TrFE-CTFE) solution was applied using a slot die in a continuous roll-to-roll process to this structured microporous PTFE membrane. The composite film was annealed and cooled as described in Example 10. The resulting composite film had a composition of 98 wt % VDF-based terpolymer and 2 wt % ePTFE.

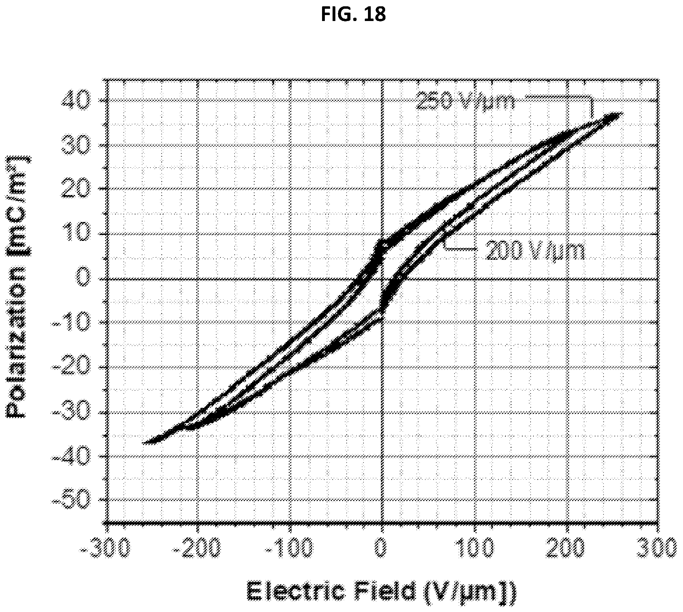

Cross-sectional SEM image analysis was used to determine composite film thickness. Electrical polarization measurements were conducted and of the polarization results are shown in Figure 18. The characterization data are summarized in Table 2.

## EXAMPLE 12

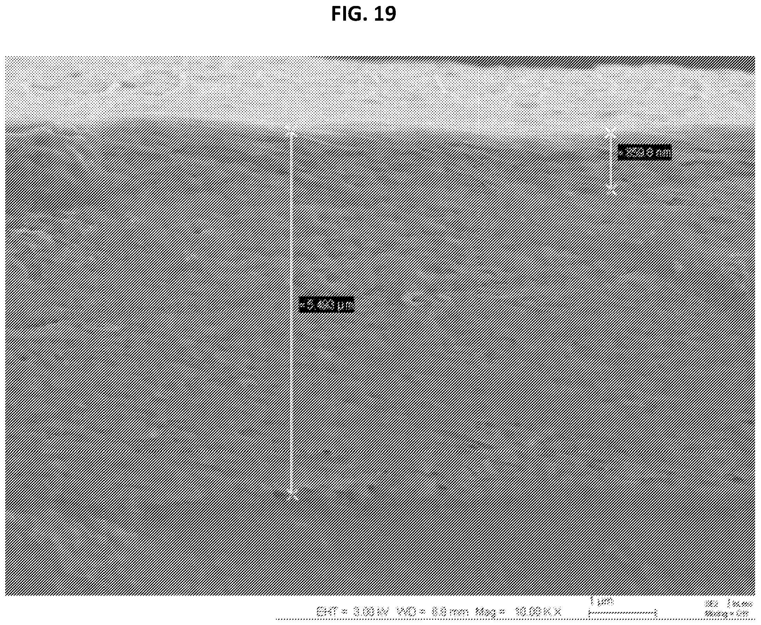

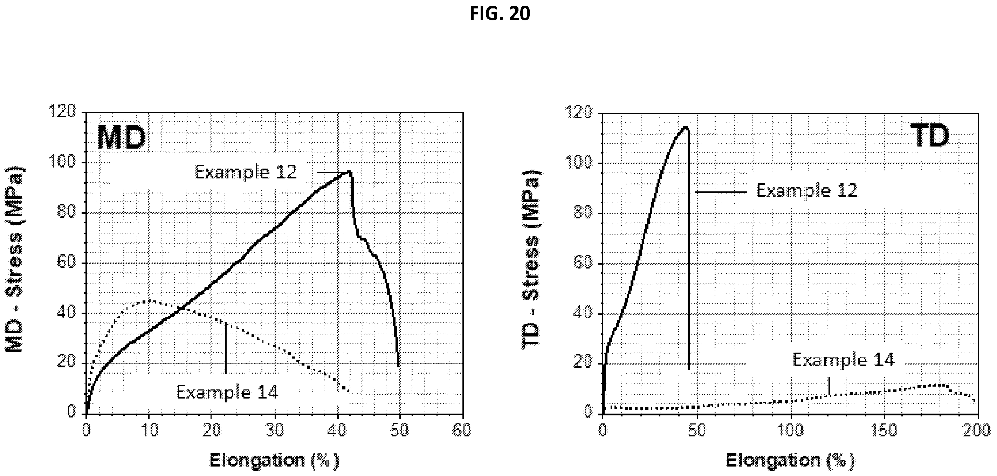

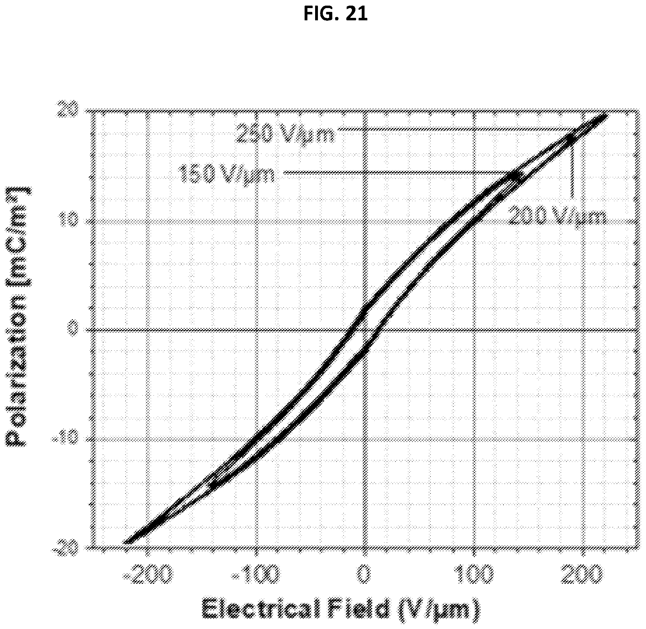

A composite ePTFE film comprising p(VDF-TrFE-CTFE) was prepared and dried following the process for Example 8 but with a higher loading of the VDF terpolymer. The resulting composite film had a composition of 60 wt % VDF terpolymer and 40 wt % ePTFE. The composite film was annealed by placing it in an oven with the temperature set at 125°C for 30 minutes. The power to the oven was then shut off and the film was left in the oven to slowly cool over approximately 24 hours until it reached room temperature (nominally 24 °C). A SEM image of a cross-section of the film is shown in Figure 19. The results of mechanical tensile testing in the machine direction (MD) and transverse direction (TD) are shown in Figure 20 (solid lines, Example 12). The results of polarization experiments are shown in Figure 21. The characterization data are summarized in Table 2.

## EXAMPLE 13

A composite ePTFE film comprising p(VDF-TrFE-CTFE) was prepared and dried following similarly to the process for Example 8 but with a different loading of the VDF terpolymer. The resulting composite film had composition of 47 wt % VDF terpolymer and 53 wt % ePTFE. The composite film was annealed and cooled as described in Example 12.

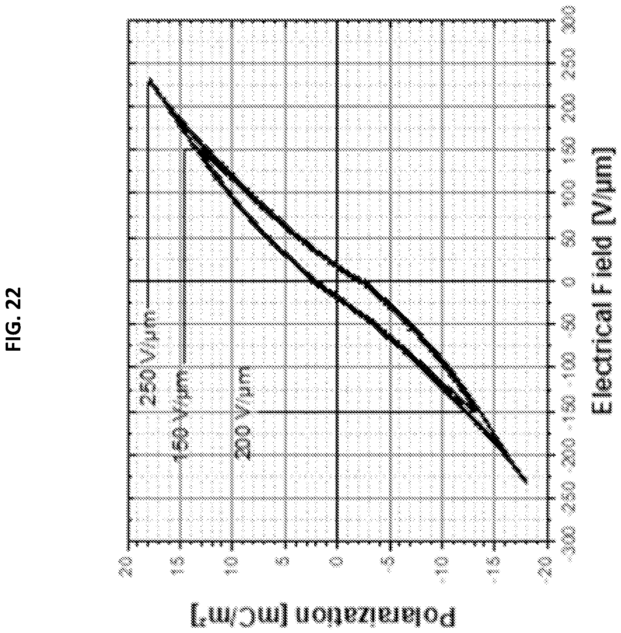

Cross-sectional SEM image analysis was used to determine composite film thickness. Electrical polarization measurements were conducted and of the polarization results are shown in Figure 22. The characterization data are summarized in Table 2.

## EXAMPLE 14

A structured microporous PTFE membrane was prepared and dried using the methods described in Examples 10 and 11 but using a high loading of the VDF terpolymer. The resulting structured composite film had a composition of 85 wt % VDF terpolymer and 15 wt % ePTFE. The structured composite film was annealed and cooled as described in Example 13.

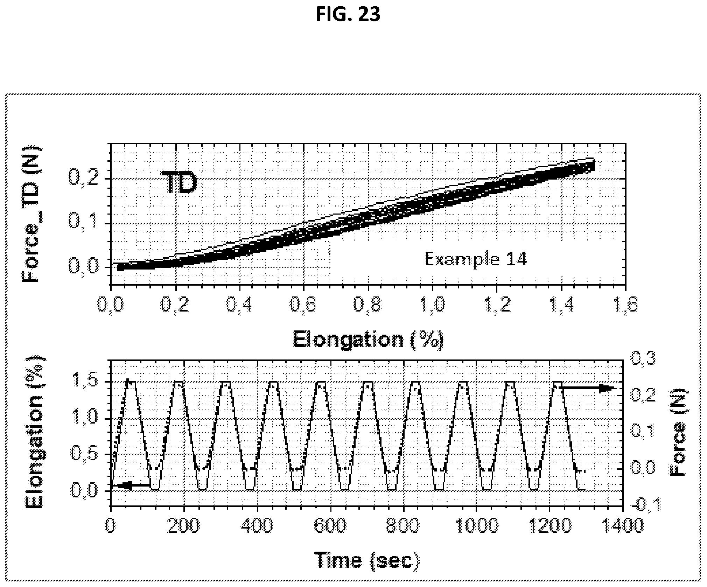

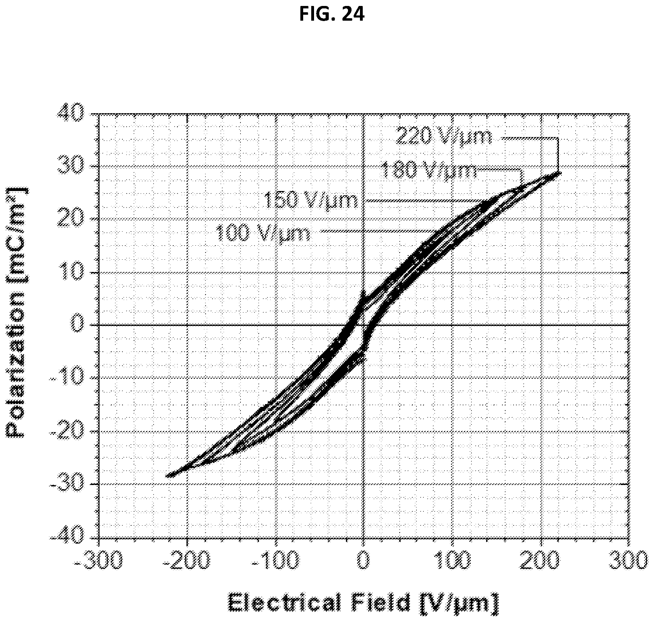

Cross-sectional SEM image analysis was used to determine composite film thickness. The results of mechanical tensile testing in the machine direction (MD) and transverse direction (TD) are shown in Figure 20 (dashed lines, Example 14) and Figure 23. The results of polarization experiments are shown in Figure 24. The characterization data are summarized in Table 2.

## EXAMPLE 15

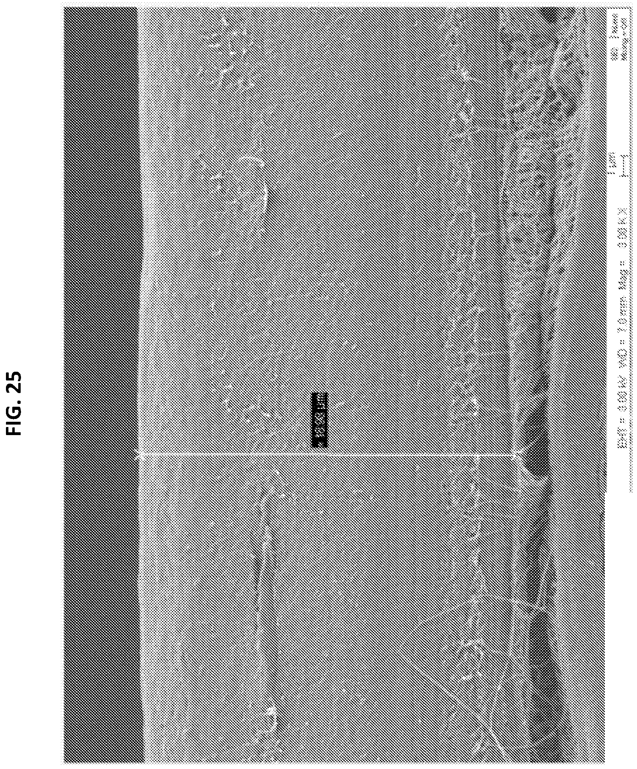

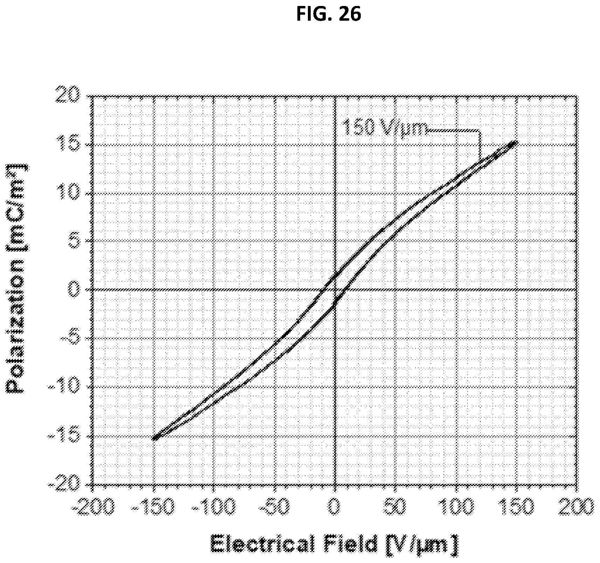

A stacked multilayer film was prepared using the general heated compression process described in Example 7 to create a 5-layer composite using the modified process parameters described below. Briefly, five layers of the composite film of Example 13 (composite ePTFE film comprising p(VDF-TrFE-CTFE)) were aligned and stacked in the press. Silicone liners were used to separate the top and bottom of the 5-layer stack from the hot plate surfaces. A pressure of 0.17 bar (2.5 psi) was applied at a temperature of 110°C for 10 minutes. The press was opened and allowed to cool to room temperature (nominally 14 °C). The 5-layer composite film was annealed and cooled as described in Example 12. The resulting 5-layer composite film had a composition of 47 wt.% VDF terpolymer and 53 wt. % ePTFE. A SEM image of the cross-section of the film is shown in Figure 25. The result of a polarization experiment is shown in Figure 26. The characterization data are summarized in Table 2.

## EXAMPLE 16

A five-layer composite film was prepared as described in Example 15 using the structured ePTFE composite film of Example 14. Briefly, five layers of the structured composite film of Example 14 were aligned and stacked in the press.

Silicone liners were used to separate the top and bottom of the 5-layer stack from the hot plate surfaces. The heated compression and annealing were conducted as described in Example 15. The resulting 5-layer composite film had a composition of 84 wt. % VDF terpolymer and 16 wt. % ePTFE.

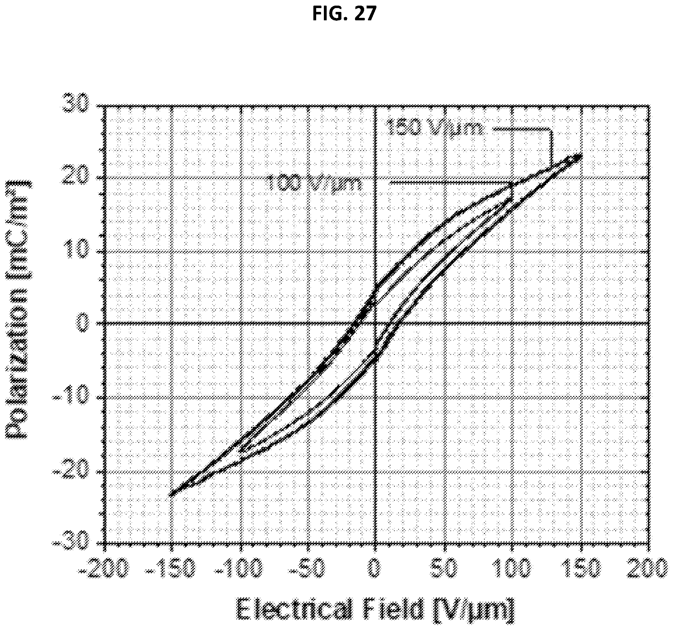

Cross-sectional SEM image analysis was used to determine the 5-layer composite film thickness. The results of polarization experiments are shown in Figure 27. The characterization data are summarized in Table 2.

## EXAMPLE 17

A monolithic film of poly (vinylidene fluoride-co-trifluoroethylene) copolymer resin ( SOLVENE® 250/P300; Solvay SA Corp, *supra)* was prepared and annealed according to the general process of Example 2.

Cross-sectional SEM image analysis was used to determine the monolithic film thickness. The characterization data are summarized in Table 2.

## EXAMPLE 18

The following examples describes the preparation and performance of a laminated 3-layered composite film having a single ePTFE / VDF-terpolymer composite film sandwiched between two VDF-copolymer monolithic films.

Briefly, the multilayer composite film was formed by the general hot press process described in Example 7 using the VDF-based terpolymer composite film of Example 14 symmetrically centered between two monolithic VDF-copolymer films of Example 17. The bonding process itself was similar to the process described for Example 7 and executed in two steps by using the hot-press.

A two-layer film was first prepared by stacking and bonding the ePTFE / VDF-based terpolymer composite film of Example 14 with the first monolithic film of Example 17 at 125 °C at 50 bar. Silicone liners were used to separate the top and bottom of the 2-layer stack from the hot plate surfaces. After this first layering step, the resulting 2-layer composite film was slowly cooled down to room temperature (nominally 24 °C). The support liner was carefully removed from this two-layer stack. The second monolithic film of Example 17 was manually aligned and bonded (using the same temperature and pressure) to the opposing side of the 2-layer composite film, forming the symmetrical 3-layer composite.

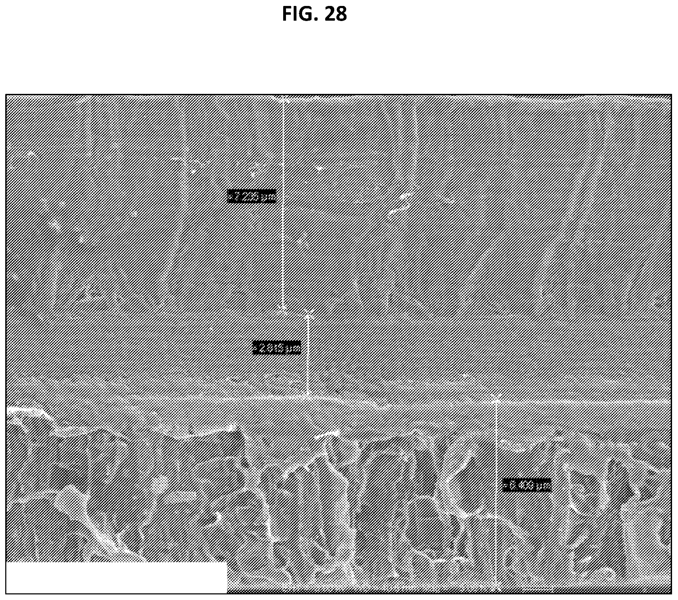

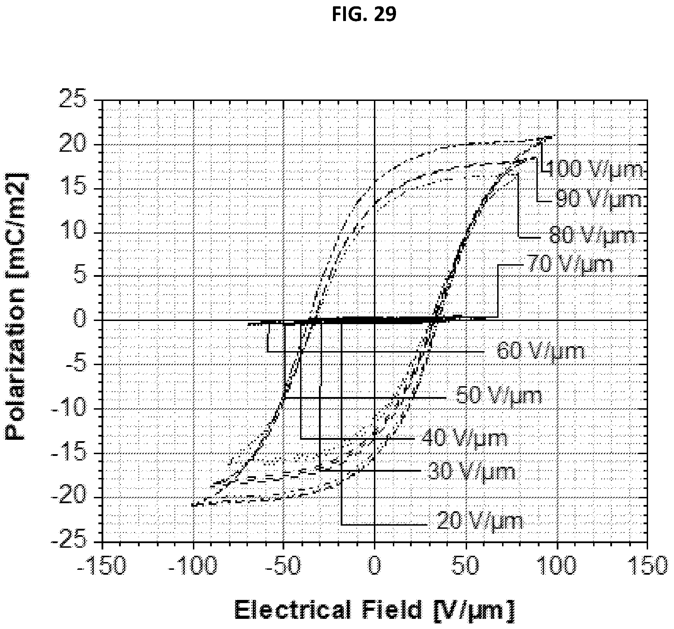

The resulting multilayer composite film composed of these three single layers had a composition of 67 wt % p(VDF-TrFE) (SOLVENE® 250/P300), 28 wt % p(VDF-TrFE-CTFE) (SOLVENE® T), and 5 wt % ePTFE. A cross-sectional SEM image of the 3-layer film is shown in Figure 28. Approximately total thickness (16.46 $\mu$m) was determined by adding the thickness of the individual layers measured on the SEM. The results of polarization experiments are shown in Figure 29. The characterization data are summarized in Table 2.

Table 1. (VDF Copolymer Monolithic Film and VDF Copolymer/ePTFE Composite Films)

| Example | Material | Film Thickness (µm) (SEM XC) | Laydown (%) (VDF /mass of circle cut) | DSC Enthalpy (J/g) | Max MD Elong. (mm) | Max TD Elong. (mm) | Voltage Breakdown Weibull alpha (V/µm) | Voltage Breakdown Weibull beta (V/µm) | Electric Field (V/µm) | Max. Polarization (mC/m²) | Coercive Field Strength (V/µm) | Piezoelectric Coefficient (d₃₃) | Remnant polarization (mC/m²) |
|---|---|---|---|---|---|---|---|---|---|---|---|---|---|
| 1 | Monolithic p(VDF-TrFE) – no anneal | 3.619 | 100 | 8.7167 | 107 | 39.5 | No data | No data | No data | No data | No data | No data | No data |
| 2 | Monolithic p(VDF-TrFE) – annealed | 4.779 | 100 | 22.051 | 9.43 | 14.6 | 234 | 4.07 | 90 | 62.5 | 84 | 4.5 | 62.5 |
| 3 | ePTFE reinforced p(VDF-TrFE) – no anneal | 6.950 | 39 | 4.7008 | 13.6 | 160 | 395.5 | 3.64 | No data | No data | No data | No data | No data |
| 4 | ePTFE reinforced p(VDF-TrFE)- annealed | 9.155 | 39 | 11.848 | 17.7 | 3.24 | 352.1 | 5.81 | 150 | 13 | 95 | 6.3 | 13 |
| 5 | ePTFE reinforced p(VDF-TrFE)- no anneal | 7.391 | 43 | 4.6546 | 32.3 | 21.3 | 440.8 | 6.64 | No data | No data | No data | No data | No data |
| 6 | ePTFE reinforced p(VDF-TrFE)- annealed | 9.155 | 43 | 13.129 | 23.9 | 22.7 | 412.8 | 12.89 | 140 | 8.2 | 78 | 2.7 | 8.2 |
| 7 | ePTFE reinforced p(VDF-TrFE)- annealed Mono/reinforced/Mono laminate | 6.989 | 71 | No data | No data | No data | No data | No data | 240 | 53 | 221 | 16 | 53 |

Table 2. (VDF Terpolymer/ePTFE Composite Films)

| Example | Material | Film Thickness (μm) (SEM XC) | Laydown (%) (VDF/mass of sample) | Max MD Elong. (mm) | Max TD Elong. (mm) | Voltage Breakdown Weibull alpha (V/μm) | Voltage Breakdown Weibull beta (V/μm) | Electric Field (V/μm) | Max. Polarization (mC/m²) | Remnant polarization (mC/m²) |
|---|---|---|---|---|---|---|---|---|---|---|
| 8 | ePTFE reinforced p(VDF-TrFE-CTFE)- annealed | 5.606 | 53 | No data | No data | 300 | 12.3 | 160 | 17.2 | 3.9 |
| 9 | ePTFE reinforced p(VDF-TrFE-CTFE)- annealed | 4.622 | 52 | No data | No data | 294 | 3.01 | 290 | 23.4 | 11 |
| 10 | Compacted ePTFE reinforced p(VDF-TrFE-CTFE)- annealed | 2.339 | 84 | No data | No data | No data | No data | 275 | 35.5 | 5 |
| 11 | Compacted ePTFE reinforced p(VDF-TrFE-CTFE)- annealed | 2.63 | 98 | No data | No data | No data | No data | 250 | 36.9 | 9 |
| 12 | ePTFE reinforced p(VDF-TrFE-CTFE)- annealed | 5.493 | 60 | 111.69 | 98.22 | No data | No data | 250 | 15.6 | 2 |
| 13 | ePTFE reinforced p(VDF-TrFE-CTFE)- annealed | 4.188 | 47 | 107.58 | 121.77 | No data | No data | 230 | 18 | 2.5 |
| 14 | Compacted ePTFE reinforced p(VDF-TrFE-CTFE)- annealed | 4.992 | 85 | 16.74 | 200.64 | No data | No data | 220 | 28.2 | 5.4 |
| 15 | Multilayer Stacked ePTFE reinforced p(VDF-TrFE-CTFE)- annealed | 18.58 | 47 | No data | No data | No data | No data | 150 | 16 | 1.5 |
| 16 | Multilayer Stacked ePTFE reinforced p(VDF-TrFE-CTFE)- annealed | 21.14 | 84 | No data | No data | No data | No data | 150 | 23 | 5.2 |
| 17 | Monolithic p(VDF-TrFE) - annealed | 6.900 | 100 | No data | No data | No data | No data | No data | No data | No data |
| 18 | Multilayer Stacked ePTFE reinforced p(VDF-TrFE-CTFE) flanked by monolithic layers of p(VDF-TrFE) - annealed | 16.46 | 95 | No data | No data | No data | No data | 100 | 21 | 16 |

| Piezoelectric Coefficient (d33) (Example 18) |
|---|
| 15 |

## Claims

1. A ferroelectric article comprising:

   a. a composite film having a first side and a second side, the composite film comprising,

      i. a ferroelectric material, and
      ii. a polymeric reinforcement membrane;

   b. a first electrode electrically coupled to the first side of the composite film; and
   c. a second electrode electrically coupled to the second side of the composite film.

2. The ferroelectric article of claim 1, wherein the polymeric reinforcement membrane includes a compacted and/or retracted membrane comprising macro-structured folds and/or micro-folded fibrils.

3. The ferroelectric article of claim 1, wherein the ferroelectric material includes a ferroelectric polymer, a ferroelectric ceramic or a combination thereof.

4. The ferroelectric article of claim 3, wherein the ferroelectric polymer includes a vinylidene difluoride copolymer or terpolymer, optionally
wherein the ferroelectric polymer includes one or more of the following: poly(vinylidene fluoride-trifluoroethylene-chlorofluoroethylene), poly(vinylidene fluoride-trifluoroethylene-chlorotrifluoroethylene), poly(vinylidene fluoride-trifluoroethylene), or a combination thereof.

5. The ferroelectric article of claim 3, wherein the ferroelectric ceramic includes one or more of the following: barium strontium titanate , barium zirconium titanate, lead zirconium titanate, $PbTiO_3$ , $Pb(Mg_{1/3} Nb_{2/3})O_3$, $Pb(Mg_{1/3}Nb_{2/3}) O_3-PbTiO_3$, $LiTaO_3$, or a combination thereof, optionally
wherein the ferroelectric ceramic includes one or more of the following: nanoparticles, nanowires, nanorods, nanocubes, nanofillers, or a combination thereof.

6. The ferroelectric article of any preceding claim, wherein the ferroelectric material includes a ferroelectric polymer and a ferroelectric ceramic particle filler.

7. The ferroelectric article of any preceding claim, wherein the polymeric reinforcement membrane includes a microporous membrane having pores, said microporous membrane including a polyolefin, a fluorinated polyolefin or a combination thereof; optionally
wherein the polymeric reinforcement membrane includes one or more of the following: ultra-high molecular weight polyethylene, polytetrafluoroethylene, polyparaxylylene, vinylidene fluoride copolymers, ethylene tetrafluoroethylene, poly (tetramethyl-p-silphenylene siloxane) or a combination thereof.

8. The ferroelectric article of any preceding claim, wherein the polymeric reinforcement membrane includes an expanded polymer having a microstructure of nodes interconnected by fibrils and a void volume defining a plurality of pores, an expanded polymer having a microstructure of substantially only fibrils and a void volume defining a plurality of pores, or a combination thereof.

9. The ferroelectric article of claim 8, wherein the expanded polymer includes one or more of the following: expanded polytetrafluoroethylene, expanded ultra-high molecular weight polyethylene, expanded polyparaxylylene, expanded VDF-co-TFE copolymer, expanded VDF-co-TrFE copolymer, expanded ethylene tetrafluoroethylene, expanded poly (tetramethyl-p-silphenylene siloxane), or a combination thereof.

10. The ferroelectric article of claims 8 or 9, wherein the microstructure of nodes, fibrils or a combination thereof of the expanded polymer is partially or fully coated with conductive metal coating to define a coated microstructure, and further wherein the coated microstructure retains at least a portion of the void volume after coating; or
wherein the ferroelectric material is partially or fully imbibed within the void volume of the polymeric reinforcement membrane.

11. The ferroelectric article of any preceding claim, wherein the ferroelectric material forms a coating on the polymeric reinforcement membrane.

12. The ferroelectric article of any preceding claim, wherein at least one of:

the composite film is equal to or greater than 1 $\mu$m and less than or equal to 20 $\mu$m thick; or
the polymeric reinforcement membrane has a mass per area of 5 g/m$^2$ or less; or
the polymeric reinforcement membrane has a mass per area of 5 g/m$^2$ or less and wherein the polymeric reinforcement membrane comprises a porosity of at least 30% as measured prior to addition of the ferroelectric material.

13. The ferroelectric article of any preceding claim wherein the composite film has a total weight, and further wherein the composite film comprises:

d. 20 wt. % or less of the polymeric reinforcement membrane based upon the total weight of the composite film; and
e. 80 wt. % or more of the ferroelectric material based upon the total weight of the composite film.

14. The ferroelectric article of any preceding claim, wherein the polymeric reinforcement membrane is biaxially oriented and has:

f. a machine direction, MD, matrix tensile strength of at least 30 MPa; and
g. a transverse direction, TD, matrix tensile strength of at least 30 MPa, and optionally
wherein the ratio of the MD matrix tensile strength to TD matrix tensile strength is 1.0 : 0.1 to 0.1 : 1.0.

15. The ferroelectric article of any preceding claim, wherein the first and/or second electrode includes:

a. a layer of a conductive metal of alumina no more than 80 nm thick;
b. a layer of conductive thermoplastic of poly(3,4-ethylenedioxythiophene) polystyrene sulfonate;
c. a layer of conductive ink comprising silver nanoparticles or silver nano wire inks deposited by digital printing, spraying, screen printing; or
d. any combination of a, b, or c.

16. The ferroelectric article of any preceding claim, wherein the ferroelectric article comprises a plurality of the composite films in a stacked configuration, optionally
wherein the plurality of composite films includes at least one laminated structure.

**17.** The ferroelectric article of claim 16, wherein at least one of:

at least one of the composite films in the stacked configuration is different from at least one of other composite films;
at least one of the composite films in the stacked configuration is of a different thickness than at least one of the other composite films;
at least one of the composite films in the stacked configuration is of a different strength than at least one of the other composite films;
at least one of the composite films in the stacked configuration is of a different orientation than at least one of the other composite films.

**18.** A device comprising the ferroelectric article of any preceding claim.

**19.** A method of making a ferroelectric article, the method comprising:

providing a polymeric reinforcement membrane having a first side and a second side; the polymeric reinforcement membrane having microstructure of nodes interconnected by fibrils or having a microstructure of substantially only fibrils, the microstructure further
defining a void volume defining a plurality of pores;
applying a ferroelectric material to the polymeric reinforcement membrane whereby a reinforced ferroelectric composite is formed; attaching at least one first electrode to said first side; and connecting at least one second electrode to said second side; whereby the ferroelectric article is formed.

**Patentansprüche**

**1.** Ferroelektrischer Artikel, umfassend:

a. eine Verbundfolie, die eine erste Seite und eine zweite Seite aufweist, wobei die Verbundfolie Folgendes umfasst,

i. ein ferroelektrisches Material und
ii. eine polymere Verstärkungsmembran;

b. eine erste Elektrode, die elektrisch mit der ersten Seite der Verbundfolie gekoppelt ist; und
c. eine zweite Elektrode, die elektrisch mit der zweiten Seite der Verbundfolie gekoppelt ist.

**2.** Ferroelektrischer Artikel nach Anspruch 1, wobei die polymere Verstärkungsmembran eine verdichtete und/oder zusammengezogene Membran enthält, die makrostrukturierte Falten und/oder mikrogefaltete Fasern umfasst.

**3.** Ferroelektrischer Artikel nach Anspruch 1, wobei das ferroelektrische Material ein ferroelektrisches Polymer, eine ferroelektrische Keramik oder eine Kombination davon enthält.

**4.** Ferroelektrischer Artikel nach Anspruch 3, wobei das ferroelektrische Polymer ein Vinylidendifluorid-Copolymer oder -Terpolymer enthält, optional
wobei das ferroelektrische Polymer eines oder mehrere von Folgenden enthält: Poly(vinylidenfluorid-trifluorethylen-chlorfluorethylen), Poly(vinylidenfluorid-trifluorethylen-chlortrifluorethylen), Poly(vinylidenfluorid-trifluorethylen) oder eine Kombination davon.

**5.** Ferroelektrischer Artikel nach Anspruch 3, wobei die ferroelektrische Keramik eines oder mehrere von Folgenden enthält: Bariumstrontiumtitanat, Bariumzirkoniumtitanat, Bleizirkoniumtitanat, $PbTiO_3$, $Pb(Mg_{1/3}Nb_{2/3})O_3$, $Pb(Mg_{1/3}Nb_{2/3})O_3$-$PbTiO_3$, $LiTaO_3$ oder eine Kombination davon, optional
wobei die ferroelektrische Keramik eines oder mehrere von Folgenden enthält: Nanopartikel, Nanodrähte, Nanostäbe, Nanowürfel, Nanofüllstoffe oder eine Kombination davon.

**6.** Ferroelektrischer Artikel nach einem vorhergehenden Anspruch, wobei das ferroelektrische Material ein ferroelektrisches Polymer und einen ferroelektrischen keramischen Partikelfüllstoff enthält.

7.  Ferroelektrischer Artikel nach einem vorhergehenden Anspruch, wobei die polymere Verstärkungsmembran eine mikroporöse Membran mit Poren enthält, wobei die mikroporöse Membran ein Polyolefin, ein fluoriertes Polyolefin oder eine Kombination davon enthält; optional
    wobei die polymere Verstärkungsmembran eines oder mehrere von Folgenden enthält: Polyethylen mit ultrahohem Molekulargewicht, Polytetrafluorethylen, Polyparaxylylen, Vinylidenfluorid-Copolymere, Ethylentetrafluorethylen, Poly(tetramethyl-p-silphenylensiloxan) oder eine Kombination davon.

8.  Ferroelektrischer Artikel nach einem vorhergehenden Anspruch, wobei die polymere Verstärkungsmembran ein geschäumtes Polymer mit einer Mikrostruktur von Knoten, die durch Fasern miteinander verbunden sind, und einem Hohlraumvolumen, das eine Vielzahl von Poren definiert, ein geschäumtes Polymer mit einer Mikrostruktur von im Wesentlichen nur Fasern und einem Hohlraumvolumen, das eine Vielzahl von Poren definiert, oder eine Kombination davon enthält.

9.  Ferroelektrischer Artikel nach Anspruch 8, wobei das geschäumte Polymer eines oder mehrere von Folgenden enthält: geschäumtes Polytetrafluorethylen, geschäumtes Polyethylen mit ultrahohem Molekulargewicht, geschäumtes Polyparaxylylen, geschäumtes VDF-*co*-TFE-Copolymer, geschäumtes VDF-*co*-TrFE-Copolymer, geschäumtes Ethylentetrafluorethylen, geschäumtes Poly(tetramethyl-p-silphenylensiloxan) oder eine Kombination davon.

10. Ferroelektrischer Artikel nach Anspruch 8 oder 9, wobei die Mikrostruktur von Knoten, Fasern oder einer Kombination davon des geschäumten Polymers teilweise oder vollständig mit einer leitfähigen Metallbeschichtung beschichtet ist, um eine beschichtete Mikrostruktur zu definieren, und wobei ferner die beschichtete Mikrostruktur mindestens einen Teil des Hohlraumvolumens nach der Beschichtung beibehält; oder
    wobei das ferroelektrische Material teilweise oder vollständig innerhalb des Hohlraumvolumen der polymeren Verstärkungsmembran aufgenommen ist.

11. Ferroelektrischer Artikel nach einem vorhergehenden Anspruch, wobei das ferroelektrische Material eine Beschichtung auf der polymeren Verstärkungsmembran ausbildet.

12. Ferroelektrischer Artikel nach einem vorhergehenden Anspruch, wobei mindestens eines von Folgenden gilt:

    die Verbundfolie ist gleich oder größer als 1 $\mu$m und kleiner als oder gleich 20 $\mu$m dick; oder
    die polymere Verstärkungsmembran weist eine Masse pro Fläche von 5 g/m$^2$ oder weniger auf; oder
    die polymere Verstärkungsmembran weist eine Masse pro Fläche von 5 g/m$^2$ oder weniger auf
    und wobei die polymere Verstärkungsmembran eine Porosität von mindestens 30 %, gemessen vor der Zugabe des ferroelektrischen Materials, umfasst.

13. Ferroelektrischer Artikel nach einem vorhergehenden Anspruch, wobei die Verbundfolie ein Gesamtgewicht aufweist und ferner wobei die Verbundfolie Folgendes umfasst:

    d. 20 Gew.-% oder weniger polymere Verstärkungsmembran basierend auf dem Gesamtgewicht der Verbundfolie; und
    e. 80 Gew.-% oder mehr ferroelektrisches Material basierend auf dem Gesamtgewicht der Verbundfolie.

14. Ferroelektrischer Artikel nach einem vorhergehenden Anspruch, wobei die polymere Verstärkungsmembran biaxial orientiert ist und Folgendes aufweist:

    f. eine Matrixzugfestigkeit in Maschinenrichtung, MD, von mindestens 30 MPa; und
    g. eine Matrixzugfestigkeit in Querrichtung, TD, von mindestens 30 MPa und optional
    wobei das Verhältnis der MD-Matrixzugfestigkeit zur TD-Matrixzugfestigkeit 1,0 : 0,1 bis 0,1 : 1,0 beträgt.

15. Ferroelektrischer Artikel nach einem vorhergehenden Anspruch, wobei die erste und/oder die zweite Elektrode Folgendes enthält:

    a. eine Schicht aus einem leitfähigen Metall aus Aluminiumoxid mit einer Dicke von nicht mehr als 80 nm;
    b. eine Schicht aus leitfähigem Thermoplast aus Poly(3,4-ethylendioxythiophen)polystyrolsulfonat;
    c. eine Schicht aus leitfähiger Tinte, die Silbernanopartikel oder Silbernanodrahttinten umfasst, die durch Digitaldruck, Sprühen, Siebdruck abgeschieden wurden; oder

d. jede Kombination von a, b oder c.

16. Ferroelektrischer Artikel nach einem vorhergehenden Anspruch, wobei der ferroelektrische Artikel eine Vielzahl der Verbundfolien in einer gestapelten Konfiguration umfasst, wobei die Vielzahl von Verbundfolien optional mindestens eine laminierte Struktur enthält.

17. Ferroelektrischer Artikel nach Anspruch 16, wobei mindestens eines von Folgenden gilt:

mindestens eine der Verbundfolien in der gestapelten Konfiguration unterscheidet sich von mindestens einer von anderen Verbundfolien;
mindestens eine der Verbundfolien in der gestapelten Konfiguration ist von einer anderen Dicke als mindestens eine der anderen Verbundfolien;
mindestens eine der Verbundfolien in der gestapelten Konfiguration ist von einer anderen Festigkeit als mindestens eine der anderen Verbundfolien;
mindestens eine der Verbundfolien in der gestapelten Konfiguration ist von einer anderen Orientierung als mindestens eine der anderen Verbundfolien.

18. Vorrichtung, umfassend den ferroelektrischen Artikel nach einem vorhergehenden Anspruch.

19. Verfahren zum Herstellen eines ferroelektrischen Artikels, wobei das Verfahren Folgendes umfasst:

Bereitstellen einer polymeren Verstärkungsmembran, die eine erste Seite und eine zweite Seite aufweist; wobei die polymere Verstärkungsmembran eine Mikrostruktur von Knoten aufweist, die durch Fasern miteinander verbunden sind, oder eine Mikrostruktur von im Wesentlichen nur Fasern aufweist, wobei die Mikrostruktur ferner ein Hohlraumvolumen definiert, das eine Vielzahl von Poren definiert;
Aufbringen eines ferroelektrischen Materials auf die polymere Verstärkungsmembran, wodurch ein verstärkter ferroelektrischer Verbundstoff ausgebildet wird;
Anbringen mindestens einer ersten Elektrode an der ersten Seite; und
Verbinden mindestens einer zweiten Elektrode mit der zweiten Seite; wodurch der ferroelektrische Artikel ausgebildet wird.

**Revendications**

1. Article ferroélectrique comprenant :

a. un film composite comportant un premier côté et un second côté, le film composite comprenant :

i. un matériau ferroélectrique, et
ii. une membrane de renforcement polymère ;

b. une première électrode couplée électriquement au premier côté du film composite ; et
c. une seconde électrode couplée électriquement au second côté du film composite.

2. Article ferroélectrique de la revendication 1, dans lequel la membrane de renforcement polymère comprend une membrane compactée et/ou rétractée comprenant des plis macrostructurés et/ou des fibrilles micropliées.

3. Article ferroélectrique de la revendication 1, dans lequel le matériau ferroélectrique comprend un polymère ferroélectrique, une céramique ferroélectrique ou une combinaison de ceux-ci.

4. Article ferroélectrique de la revendication 3, dans lequel le polymère ferroélectrique comprend un copolymère ou terpolymère de difluorure de vinylidène, éventuellement
dans lequel le polymère ferroélectrique comprend un ou plusieurs des éléments suivants : poly(fluorure de vinylidène-trifluoroéthylène-chlorofluoroéthylène), poly(fluorure de vinylidène-trifluoroéthylène-chlorotrifluoroéthylène), poly(fluorure de vinylidène-trifluoroéthylène), ou une combinaison de ceux-ci.

5. Article ferroélectrique de la revendication 3, dans lequel la céramique ferroélectrique comprend un ou plusieurs des éléments suivants : titanate de baryum et de strontium, titanate de baryum et de zirconium, titanate de plomb et de

zirconium, $PbTiO_3$, $Pb(Mg_{1/3}Nb_{2/3})0_3$, $Pb(Mg_{1/3}Nb_{2/3})O_3$-$PbTiO_3$, $LiTaO_3$, ou une combinaison de ceux-ci, éventuellement
dans lequel la céramique ferroélectrique comprend un ou plusieurs des éléments suivants : nanoparticules, nanofils, nanotiges, nanocubes, nanocharges ou une combinaison de ceux-ci.

6. Article ferroélectrique d'une quelconque revendication précédente, dans lequel le matériau ferroélectrique comprend un polymère ferroélectrique et une charge de particules céramiques ferroélectriques.

7. Article ferroélectrique d'une quelconque revendication précédente, dans lequel la membrane de renforcement polymère comprend une membrane microporeuse comportant des pores, ladite membrane microporeuse comprenant une polyoléfine, une polyoléfine fluorée ou une combinaison de celles-ci ; éventuellement
dans lequel la membrane de renforcement polymère comprend un ou plusieurs des éléments suivants : polyéthylène de poids moléculaire ultra-élevé, polytétrafluoroéthylène, polyparaxylylène, copolymères de fluorure de vinylidène, éthylène tétrafluoroéthylène, poly (tétraméthyl-p-silphénylène siloxane) ou une combinaison de ceux-ci.

8. Article ferroélectrique d'une quelconque revendication précédente, dans lequel la membrane de renforcement polymère comprend un polymère expansé comportant une microstructure de nœuds interconnectés par des fibrilles et un volume vide définissant une pluralité de pores, un polymère expansé comportant une microstructure essentiellement composée uniquement de fibrilles et un volume vide définissant une pluralité de pores, ou une combinaison de ceux-ci.

9. Article ferroélectrique de la revendication 8, dans lequel le polymère expansé comprend un ou plusieurs des éléments suivants : polytétrafluoroéthylène expansé, polyéthylène de poids moléculaire ultra-élevé expansé, polyparaxylylène expansé, copolymère VDF-*co*-TFE expansé, copolymère VDF- co-TrFE expansé, éthylène tétrafluoroéthylène expansé, poly (tétraméthyl-p-silphénylène siloxane) expansé, ou une combinaison de ceux-ci.

10. Article ferroélectrique des revendications 8 ou 9, dans lequel la microstructure de nœuds, de fibrilles ou d'une combinaison de ceux-ci du polymère expansé est partiellement ou entièrement revêtue d'un revêtement métallique conducteur pour définir une microstructure revêtue, et dans lequel, en outre, la microstructure revêtue conserve au moins une partie du volume vide après revêtement ; ou
dans lequel le matériau ferroélectrique est partiellement ou entièrement imbibé dans le volume vide de la membrane de renforcement polymère.

11. Article ferroélectrique d'une quelconque revendication précédente, dans lequel le matériau ferroélectrique forme un revêtement sur la membrane de renforcement polymère.

12. Article ferroélectrique d'une quelconque revendication précédente, dans lequel au moins l'une des propositions suivantes s'applique :

le film composite présente une épaisseur égale ou supérieure à 1 $\mu$m et inférieure ou égale à 20 $\mu$m ; ou
la membrane de renforcement polymère comporte une masse par surface de 5 g/m$^2$ ou moins ; ou
la membrane de renforcement polymère comporte une masse par surface de 5 g/m$^2$ ou moins et la membrane de renforcement polymère comprend une porosité d'au moins 30 % telle que mesurée avant l'addition du matériau ferroélectrique.

13. Article ferroélectrique d'une quelconque revendication précédente, dans lequel le film composite comporte un poids total, et dans lequel en outre le film composite comprend :

d. 20 % en poids ou moins de la membrane de renforcement polymère sur la base du poids total du film composite ; et
e. 80 % en poids ou plus du matériau ferroélectrique sur la base du poids total du film composite.

14. Article ferroélectrique d'une quelconque revendication précédente, dans lequel la membrane de renforcement polymère est orientée biaxialement et comporte :

f. une résistance à la traction de matrice dans une direction de machine, MD, d'au moins 30 MPa ; et
g. une résistance à la traction de matrice dans une direction transversale, TD, d'au moins 30 MPa, et éventuellement

dans lequel le rapport de la résistance à la traction de matrice MD sur la résistance à la traction de matrice TD est de 1,0 : 0,1 à 0,1 : 1,0.

15. Article ferroélectrique d'une quelconque revendication précédente, dans lequel la première et/ou la seconde électrode comprend :

    a. une couche d'un métal conducteur d'alumine d'une épaisseur non supérieure à 80 nm ;
    b. une couche de thermoplastique conducteur de poly(3,4-éthylènedioxythiophène) polystyrène sulfonate ;
    c. une couche d'encre conductrice comprenant des nanoparticules d'argent ou des encres à nanofils d'argent déposées par impression numérique, pulvérisation, sérigraphie ; ou
    d. toute combinaison de a, b ou c.

16. Article ferroélectrique d'une quelconque revendication précédente, dans lequel l'article ferroélectrique comprend une pluralité de films composites dans une configuration empilée, éventuellement dans lequel la pluralité de films composites comprend au moins une structure stratifiée.

17. Article ferroélectrique de la revendication 16, dans lequel au moins l'une des propositions suivantes s'applique :

    au moins un des films composites dans la configuration empilée est différent d'au moins un des autres films composites ;
    au moins un des films composites dans la configuration empilée présente une épaisseur différente de celle d'au moins un des autres films composites ;
    au moins un des films composites dans la configuration empilée présente une résistance différente de celle d'au moins un des autres films composites ;
    au moins un des films composites dans la configuration empilée présente une orientation différente de celle d'au moins un des autres films composites.

18. Dispositif comprenant l'article ferroélectrique d'une quelconque revendication précédente.

19. Procédé de fabrication d'un article ferroélectrique, le procédé comprenant :

    la fourniture d'une membrane de renforcement polymère comportant un premier côté et un second côté ; la membrane de renforcement polymère comportant une microstructure de nœuds interconnectés par des fibrilles ou comportant une microstructure constituée essentiellement uniquement de fibrilles, la microstructure définissant en outre un volume vide définissant une pluralité de pores ;
    l'application d'un matériau ferroélectrique à la membrane de renforcement polymère, moyennant quoi un composite ferroélectrique renforcé est formé ;
    la fixation d'au moins une première électrode audit premier côté ; et
    la connexion d'au moins une seconde électrode audit second côté ; moyennant quoi l'article ferroélectrique est formé.

**FIG. 1**

FIG. 2

Enthalpy (normalized): 8.7167 J/g
Peak temperature: 108.13 °C

Enthalpy (normalized): 22.051 J/g
Peak temperature: 117.29 °C

— Example 1
--- Example 2

Heat Flow (Normalized) $Q$ (W/g)

Temperature $T$ (°C)

FIG. 3

EP 4 477 041 B1

**FIG. 4**

EP 4 477 041 B1

EP 4 477 041 B1

FIG. 5

28

FIG. 6

FIG. 7

FIG. 8

**FIG. 9**

**FIG. 10**

FIG. 11

Example 5

EP 4 477 041 B1

**FIG. 12**

FIG. 13

FIG. 14

EP 4 477 041 B1

FIG. 15

EP 4 477 041 B1

**FIG. 16**

**FIG. 17**

FIG. 18

EP 4 477 041 B1

FIG. 19

**FIG. 20**

**FIG. 21**

FIG. 22

**FIG. 23**

FIG. 24

**FIG. 25**

FIG. 26

FIG. 27

**FIG. 28**

**FIG. 29**

**EP 4 477 041 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 63309338 A
- TW 201347564 A
- WO 2010008133 A1
- WO 2008031657 A1
- EP 3061598 A1, Zaggl
- US 9849629 B, Zaggl
- US 3953566 A, Gore
- US 10577468 B, Sbriglia
- US 9732184 B, Sbriglia
- US 10266670 B, Sbriglia
- US 9932429 B, Sbriglia
- US 20160032069 A, Sbriglia
- US 3315020 A, Gore
- US 7083225 A, Baille
- WO 2021202628 A1
- US 7306729 B, Bacino
- US 5476589 A, Bacino
- US 5183545 A, Branca
- US 5708044 A, Branca
- US 6541589 B, Baillie
- US 7531611 B, Sabol
- US 8637144 B, Ford
- US 9139669 B, Xu
- US 9139707 B, Xu
- US 8658707 B, Xu
- WO 2016135188 A, Zaggl

### Non-patent literature cited in the description

- **QIU et al.** *J. Appl. Phys.*, 2013, vol. 113, 224106-1, 224106-8
- Direct Piezoelectric Measurement: The Berlincourt Method. In: Characterisation of Ferroelectric Bulk Materials and Thin Films. **STEWART M.** ; **CAIN M.G.** Springer Series in Measurement Science and Technology. Springer, 2014, vol. 2
- *CHEMICAL ABSTRACTS*, 28960-88-5